(19) Europäisches Patentamt
European Patent Office
Office européen des brevets

(11) **EP 1 613 792 B1**

(12) **EUROPEAN PATENT SPECIFICATION**

(45) Date of publication and mention
of the grant of the patent:
**01.01.2014   Bulletin 2014/01**

(21) Application number: **04716180.7**

(22) Date of filing: **01.03.2004**

(51) Int Cl.:
***C23C 16/455*** (2006.01)

(86) International application number:
**PCT/US2004/006342**

(87) International publication number:
**WO 2004/083485 (30.09.2004 Gazette 2004/40)**

(54) **METHODS AND APPARATUS FOR ATOMIC LAYER DEPOSITION**

VERFAHREN UND VORRICHTUNG ZUR ATOMSCHICHTABSCHEIDUNG

PROCEDES ET APPAREIL POUR PERFECTIONNEMENTS AU TEMPS DE CYCLE POUR DEPOT EN COUCHES ATOMIQUES

(84) Designated Contracting States:
**AT BE BG CH CY CZ DE DK EE ES FI FR GB GR HU IE IT LI LU MC NL PL PT RO SE SI SK TR**

(30) Priority: **14.03.2003   US 455034 P**

(43) Date of publication of application:
**11.01.2006   Bulletin 2006/02**

(73) Proprietor: **GENUS, INC.**
**Sunnyvale, CA 94086 (US)**

(72) Inventors:
• **LIU, Xinye**
  **Sunnyvale, California 94087 (US)**
• **SEIDEL, Thomas, E.**
  **Sunnyvale, CA 94087 (US)**
• **LEE, Edward**
  **Cupertino**
  **CA 95014 (US)**
• **DOERING, Ken**
  **San Jose, CA 95138 (US)**
• **RAMANATHAN, Sasangan**
  **San Ramon, CA 94583 (US)**

(74) Representative: **Grundmann, Dirk et al**
**RIEDER & PARTNER**
**Patentanwälte - Rechtsanwalt**
**Postfach 11 04 51**
**42304 Wuppertal (DE)**

(56) References cited:
**US-A1- 2001 054 377     US-A1- 2002 076 508**
**US-A1- 2003 013 320**

**Description**

The invention is related to an atomic layer deposition (ALD) apparatus of the preamble of claim 1 and a method of the preamble of claim 25.

The invention relates to thin film processing and, more particularly to methods and to apparatus for improvement in the cycle time of atomic layer deposition (ALD) processes.

ALD-processes are known from US 2002/0076508 A1. A reactor chamber is provided. A first purge flow pathway is coupled upstream of the reactor chamber. There are valves to provide a first purge flow through the first purges flow pathway during an exposure period wherein precursors are injected into the process chamber. To quickly remove gases precursors out of the process chamber the chamber conductance can be increased by lowering a shield. During a purge period the reactor chamber is purged by a purged flow.

US 2003/00133201 show an atomic layer deposition apparatus having a pumpkin arrangement comprising a throttle valves which can be opened and closed during the delusion of an non chemically adsorbed precursor the reactor pressure is increased by closing the throttle valve.

In the field of material deposition, a process known as atomic layer deposition (ALD) has emerged as a promising candidate to extend the abilities of chemical vapor deposition (CVD) techniques. Generally ALD is a process wherein conventional CVD processes are divided into individual, sequential deposition steps that theoretically achieve saturation (and exhibit self-limited growth) at the level of a single molecular or atomic layer thickness. After each deposition step, unreacted chemical precursors used therein (and the unwanted byproducts of the reaction) must be removed from the reactor chamber. Existing techniques for doing so include the so-called "pump" or "evacuation" method and the "purge" or "flow" method. Of these, the purge or flow procedures have become the method of choice for commercial operation of ALD reactors because the efficiency of precursor removal by purge is improved over that provided by evacuation. See, e.g., M. Ritala and M. Leskela, "Deposition and Processing" in Handbook of Thin Film Materials, H.S. Nalwa (ed.), Vol. 1, Ch. 2 (2002).

In the purge or flow method, chemical molecular precursors are introduced separately into a reactor. Typically, each precursor exposure is followed by an inert gas purge to assist in the removal of the extra reactive precursor chemicals from the reactor just prior to the introduction of the next precursor. This sequence of steps may be repeated several times to provide for the complete formation of a desired material film. The total time to carry out the series of sequential steps or "periods" of: (i) exposure of precursor A, (ii) inert or neutral gas purge (for removal of unreacted precursor A), (iii) exposure of precursor B, and (iv) inert or neutral gas purge (for removal of unreacted precursor B), is called the "cycle time" (CT). The above 4 periods are called expose period of A, purge period of A, expose period of B, and purge period of B, respectively. The time period that consists of expose period of A and the following purge period of A is called half cycle A. Similarly, the time period that consists of expose period of B and the following purge period of B is called half cycle B.

To provide for greater wafer throughput, it is a goal of semiconductor manufacturers to reduce the CT of ALD processes. Many pulse/purge times are reported in the literature and it is commonly found that the purge times are long relative to the exposure pulse times. This is particularly true when very good film uniformity over large area substrates is desired. Thus, in the current state of the art, it is generally the purge component(s) of ALD cycles that provide(s) the limiting factors on the CT. Indeed, a typical case may utilize purge times 1.5 - 5 times longer than the exposure times. Note that this is true even in the case of plasma-assisted ALD processes in which only a single purge process is required. See, e.g., U.S. Patent 6,200,893 of Sneh, assigned to the assignee of the present invention.

To provide for the desired increase in wafer throughput then, cycle time reductions, and in particular purge time reductions, are needed. One way in which this can be accomplished is to provide an increased flow for the purge gas. Providing the purge gas at a higher flow rate will tend to minimize the time needed to complete the purge period. However, given conventional ALD reactor designs (which utilize constant purge gas flow rates and strive to maintain constant reactor chamber pressures using a downstream throttle valve), this would tend to increase the required precursor exposure time. This is because the increased flow rate of the purge gas (which is used as a neutral carrier during the exposure periods) would tend to drive the chemical precursors out of the reactor chamber faster than would otherwise be the case at a lower purge gas flow rate. Hence, a greater loss of chemical precursor for a unit time interval could be expected and so increased exposure times would be necessary.

To avoid this situation, a bi-level purge gas flow rate could be implemented. That is, during precursor exposure a relatively low purge gas flow rate could be used (to maximize precursor residence time within the chamber) whereas during the purge period a relatively high purge gas flow rate could be used (to minimize the required purge time). The first known system to implement such a bi-level purge gas flow rate was developed in 1998 by Steven Shatas for Modular Process Technology of San Jose, CA ("MPT"). Later, in 1999, Shatas and MPT (working with one of its customers) combined the use of a bi-level purge gas flow driven by a pair of mass flow controllers with a fast-switching throttle valve downstream from the reactor chamber to permit control of both flow rate and reactor pressure. This system allowed operators to vary the residence time of the precursors during the ALD cycle, providing low residence time during precursor removal and high residence time during exposure.

More recently, a bi-level flow system using a purge bypass into a draw chamber (located downstream of the reactor chamber) during precursor exposure has been described by Sneh. See O. Sneh, WO 03/062490 A2, "ALD Apparatus and Method" (July 31, 2003). In this so-called "synchronously modulated flow draw" (SMFD) process, a high flow rate through the reactor chamber is maintained during  purge, but a low flow rate is used during deposition. The low flow rate is achieved by dumping a significant portion of the purge gas into the downstream draw chamber via a reactor bypass conduit. Thus, only a portion of the purge gas flow finds its way to the reactor chamber during the deposition sequence and so the chemical precursors are allowed to remain therein for a sufficient residence time.

Both the Shatas and Sneh systems for providing bi- or multi- level flows suffer from deficiencies. In the Shatas system, the dual purge source was provided using mass flow control components. These components are limited in their speed of response and also require ancillary flow (dumping) of the neutral purge gas during the period when the source is not injected into the reactor. This makes for relatively inefficient use of purge gas. Similarly, in the Sneh SMFD device the purge source bypasses the reactor during exposure, but the purge gas is always flowing at a high rate from its source. This tends to waste purge gas. Hence, new methods and apparatus for reducing the purge time while maintaining adequate precursor residence times are needed.

## SUMMARY OF THE INVENTION

The main embodiments of the present invention are the apparatus according to claim 1 and the method according to claim 25. In one embodiment, the present invention provides for performing an expose period (which may, in some cases, be a plasma-assisted period) of an ALD process using a first purge flow and a first pumping capacity, and performing a purge period of the ALD process using a second purge flow greater than the first purge flow and a second pumping capacity greater than the first pumping capacity. These procedures may be performed while maintaining the reactor chamber within which the ALD process is performed at a nominally constant pressure, for example through the operation of a throttle valve downstream from the reactor chamber such that the throttle valve is more open during the purge period than during the expose period. The first purge flow and the second purge flow may, in some cases, utilize different gasses and/or may be provided through different flow paths.

In some cases, the second purge flow and second pumping capacity may be initiated prior to termination of material deposition during the expose period. Alternatively, or in addition, the second purge flow and second pumping capacity may be activated so as to break turbulence within the reactor chamber (e.g., to help in the removal of precursors). Also, a second expose period of the ALD process may be performed using a third purge flow and a third pumping capacity different from the first purge flow and first pumping capacity, respectively. In some cases, the third purge flow may be an absence of a purge flow.

In various embodiments, the first purge flow may be switched to the second purge flow: at a substantially coincident point in time as the first pumping capacity is switched to the second pumping capacity, prior to completion of material deposition during the expose period, or at a different point in time than that at which the first pumping capacity is switched to the second pumping capacity. In some cases, the purge flows may be switched by switching first flow limiting conductances located upstream of the reactor chamber out of a first gas flow path thereto at a substantially coincident point in time as second flow limiting conductances located downstream of the reactor chamber are switched out of a second gas flow path from the reactor chamber.

In still further embodiments, the present invention allows for performing, within a half cycle, an expose period of an ALD process using a first purge flow defined in part by a first conductance of an annular gas flow pathway within the reactor chamber, and performing a purge period of the ALD process using a second purge flow greater than the first purge flow, the second purge flow defined in part by a second conductance of the annular gas flow pathway within the reactor chamber. The pressure of the reactor chamber may be maintained so as to be nominally constant during the expose and purge period, and in some cases, the first purge flow and the second purge flow may utilize different gasses and/or be provided through different flow paths.

Still further embodiments of the present invention provide for performing an expose period of an ALD process using a first purge flow at a first pressure, the first purge flow passing through first flow limiting conductances located within a first gas flow pathway upstream of the reactor chamber and second flow limiting conductances located within a second gas flow pathway downstream of the reactor chamber, and performing a purge period of the ALD process using a second purge flow at a second pressure greater than the first pressure, the second purge flow passing through third flow limiting conductances located within the first gas flow pathway and fourth flow limiting conductances located in the second gas flow pathway, wherein a ratio of the first flow limiting conductances to the second flow limiting conductances is equal to a ratio of the third flow limiting conductances to the fourth flow limiting conductances and a pressure of the reactor chamber is maintained nominally constant during the ALD process.

Another embodiment provides an ALD system that includes a first purge flow pathway coupled upstream of a reactor; a second purge flow pathway coupled upstream of the reactor; and a pumping arrangement coupled downstream of the reactor, and configured to be switched between a first pumping capacity when the first purge flow pathway is active and a second pumping capacity greater than the first pumping capacity when the second purge flow pathway is active. The first and second purge flow pathways may share a common gas flow manifold with one or more precursor injection pathways, or at least one of the purge flow pathways may be directly coupled to the reactor independently of the other. In some cases, the first and second pumping capacities comprise two operational modes of a single physical pump.

Additional embodiments of the present invention provide an ALD system having a purge flow pathway coupled upstream of a reactor chamber through selectable upstream flow limiting conductances having two or more operational modes including a low flow mode and a high flow mode; and a pumping arrangement coupled downstream of the reactor through selectable downstream flow limiting conductances having two or more operational modes including a low flow mode and a high flow mode, wherein the upstream flow limiting conductances and downstream flow limiting conductances are configured to switch operational modes in time-phase with one another. The upstream flow limiting conductances may be configured to switch operational modes prior to the downstream flow limiting conductances switching operational modes. In some cases, the downstream flow limiting conductances include a throttle valve, which may be an annular throttle valve located within the reactor chamber.

Still further embodiments of the present invention provide an ALD system that includes a gas delivery system coupled to a reactor chamber having disposed therein an annular throttle valve positioned within a gas flow pathway from the reactor chamber to a pumping system coupled downstream of the reactor chamber. The annular throttle valve may have two or more operating modes, each configured to provide a different flow path conductance from the reactor chamber.

## BRIEF DESCRIPTION OF THE DRAWINGS

The present invention is illustrated by way of example, and not limitation, in the figures of the accompanying drawings in which:

Figure illustrates a conventional ALD processing apparatus having a split-flow gas manifold.

Figure 2 illustrates conventional (idealized) baseline conditions for ALD reactor operation at constant pressure and flow.

Figure 3A is a graph that illustrates variations in ALD reactor flows due to the introduction of chemical precursors.

Figure 3B is a graph illustrating the effects of chemical precursor introduction on ALD reactor pressures.

Figure 4 illustrates an ALD processing apparatus configured with a two-level purge source and dual pump capacity arrangement in accordance with an embodiment of the present invention.

Figure 5 illustrates the use of a direct-coupled purge flow conduit in accordance with a further embodiment of the present invention.

Figure 6 illustrates an ALD apparatus configured to provide for multi-level purge flows through the use of tracking conductances in accordance with yet another embodiment of the present invention.

Figure 7 illustrates an ALD apparatus configured for tracking conductance operation using a direct-coupled purge gas conduit in accordance with another embodiment of the present invention.

Figure 8 illustrates an ALD apparatus configured with an annular throttle valve in accordance with still another embodiment of the present inventions.

Figure 9 illustrates various examples of annular throttle valves for use in accordance with embodiments of the present invention.

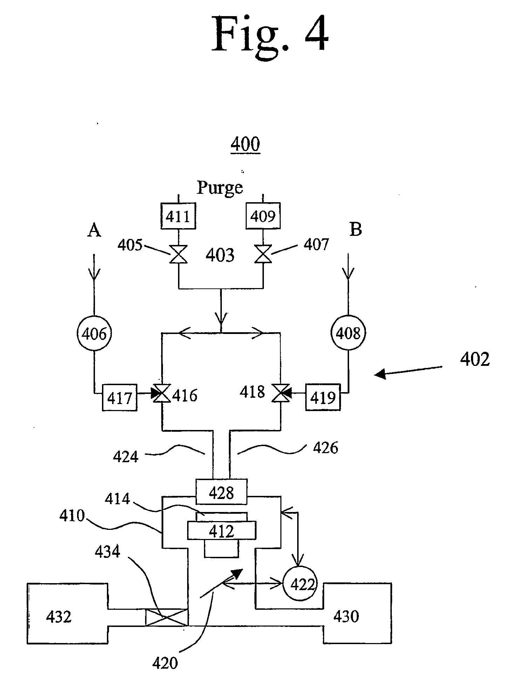

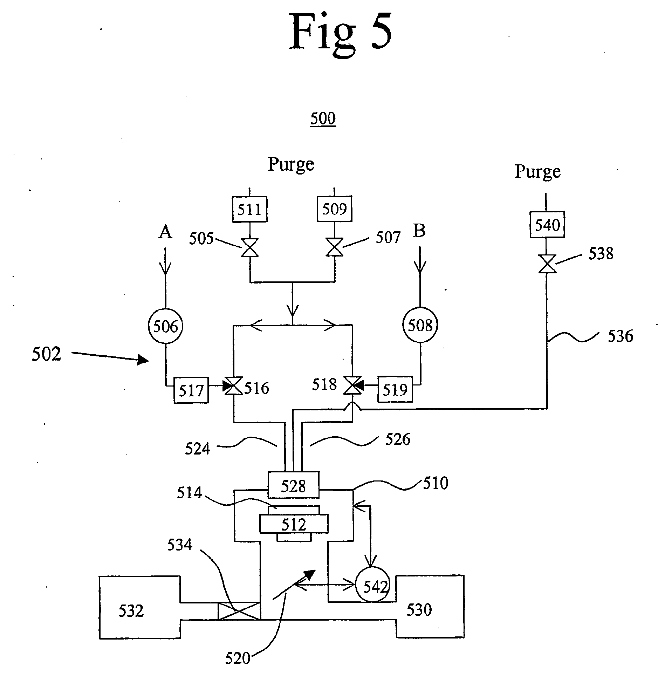

For ease of reference, reference numerals in the accompanying drawings typically are in the form "drawing number" followed by two digits, xx; for example, reference numerals on Figure 4 may be numbered 4xx; on Figure 5, reference numerals may be numbered 5xx, and so on. In certain cases, a reference numeral may be introduced on one drawing and the same reference numeral (with a different drawing number indicator) may be utilized on other drawings to refer to the same item.

## DETAILED DESCRIPTION

Described herein are methods and systems for cycle time improvements in ALD processes. In various embodiments, the present invention provides multi-level flow sources using pressure controlled and/or passive conductance components combined with a dual (or, more generally multiple) pump (or dual or multiple pump capacity) arrangement. Unlike the multi-level flow systems described above, in the present invention a high purge flow does not have to flow during the exposure pulse, resulting in more economical operation with respect to consumables usage. Both lower cost and better dynamic time-dependent performance is obtained, in some embodiments, by the use of pressure controlled components instead of mass flow controllers. Further, in some embodiments the use of an independent, direct-coupled conduit for neutral gas flow, instead of a purge bypass, provides multi-level purge source capability without the need for continual operation of a high purge flow.

In addition to reduced consumables consumption, another benefit afforded by the two or multiple level flow purge operation of the present invention is better step coverage. To achieve better step coverage, higher exposure (defined as partial pressure multiplied by exposure time) is needed. By limiting the pumping rate and the dilution of the precursor, the present invention assures that more precursor molecules reach the extremes of high aspect ratio/high topology structures and/or the bottom of trenches in a given expose period.

It should be remembered that the various embodiments described herein are intended merely to illustrate systems and methods incorporating the present invention and are not to limit the overall scope of the invention. The principle of time-phased, multi-level flow to vary residence time during ALD processes may described in terms of a method for varying flows and also controlling pressure over the ALD cycle and there are many different ways to implement the procedure. For example, in the case of no limiting constraints, such as operation at non-constant reactor chamber pressure, an ideal sequence may be:

i) Close by command (or move toward the closed position) a downstream throttle valve during reactant exposure time. This allows the precursor to reside a sufficiently long enough time in the chamber to achieve substantially about or more than 99% completion of the saturating ALD half-reaction.

ii) Remove the extra precursor as quickly as possible. This may be done by driving the purge gas flow rate to higher values during the purge period by the switching action using an upstream higher-pressure level source.

Where, however, the reactor chamber pressure is to be constrained at a nominally constant pressure, the present invention allows for the same by maintaining the throttle valve less open at low flow rates during reactant exposure and more open at high flow rates during purge. Further, because an ALD half-reaction for a first precursor (A) may be very different from that for a second precursor (B), the flow rates during the A cycle and the B cycle may be different. To accommodate the need for varying exposure flow rates due to different precursor requirements, the present invention provides for a "multivalue" or multi-level" flow rate, consisting of two or more flow levels.

In general then the present invention provides systems and methods that provide low flow levels concurrently matched to low pumping capacities during exposure times and high flow levels concurrently matched with higher pumping capacities during purge times. Other cycle time improvement techniques that are known in the art, such as those due to chemical delivery assistance using flow controllers or pressure controlled methods (see, e.g., U.S. Patent 6,503,330, assigned to the assignee of the present invention and incorporated herein by reference), or ALD precursors delivered from "charge tubes" (see, e.g., Gadgil et al., WO0079019) or pressurized precursor volumes may be used in conjunction with the present methods and apparatus.

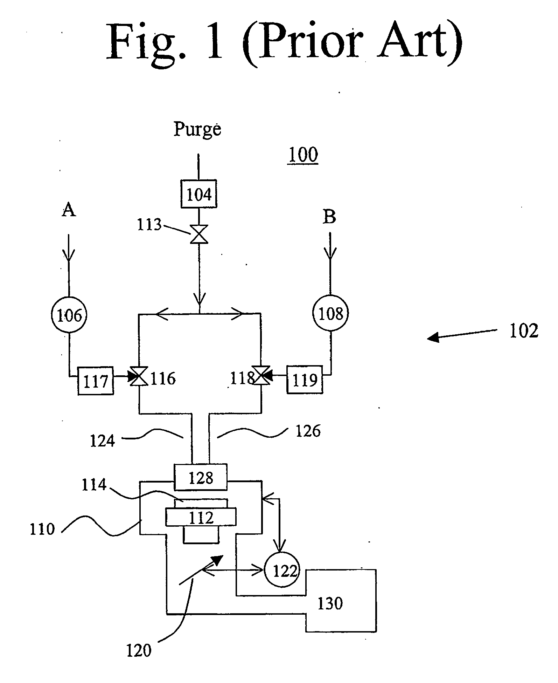

Before describing embodiments of the present invention in detail it is helpful to present some background regarding state of the art ALD reactor design. This will provide readers unfamiliar with the technology sufficient basis to better appreciate the present invention. Thus, we refer first to **Figure 1**, which shows an ALD processing system 100 and is adapted from the above-cited U.S. Patent of the present assignee.

ALD processing system 100 includes a split-flow gas switching manifold 102, through which a neutral purge gas (from source 104) and one or more chemical sources (or process gasses) 106 and 108 may be delivered to reactor chamber 110. Neutral carrier gases may or may not accompany the chemical precursor. Within the chamber 110 is a heater assembly 112, upon which rests a semiconductor wafer 114. When both shut-off valves 116 and 118 are closed, and neutral purge gas flows through the reactor 110, baseline purge flow and pressure conditions are established. In general, the split-flow manifold can include one or more inject conduits to the reactor 110; and system 100 is illustrated with a dual inject.

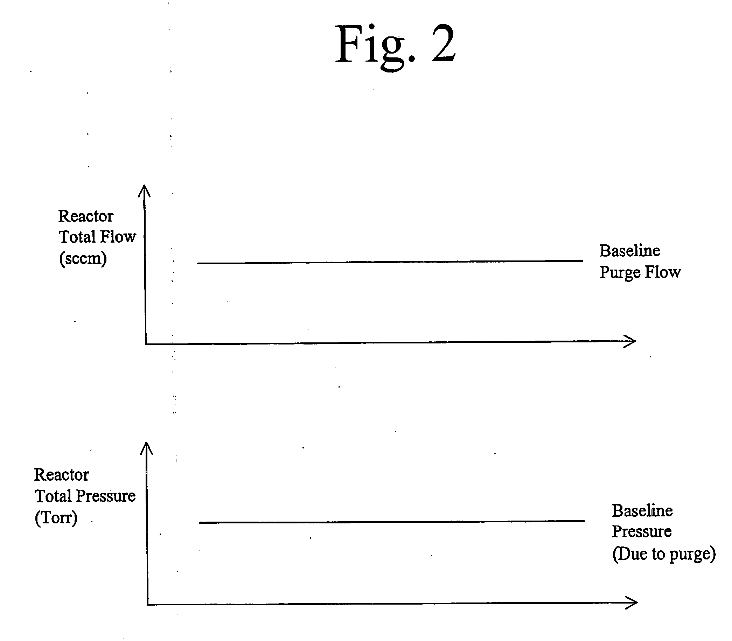

Prior to precursor injection, the flows and pressure in the reactor 110 are determined by: the upstream pressure setting at purge gas source 104, the pressure setting at the reactor chamber 110 and the operation of the downstream throttle valve 120. The throttle valve 120 is part of a closed loop, feedback control system 122, which operates to keep the pressure in the reactor chamber constant (or nearly so) as the various chemical precursors are introduced into the reactor 110. Various "restrictors" and conduit conductance limitations as may be useful may be placed in the gas switching manifold 102 (e.g., in reactor purge pathways 126 and 124), but are not shown in detail. Where used such restrictors and conductances may also determine the quantitative pressure and flow values. Overall though, the split-flow architecture provides a nominally constant gas pressure and (continuous) flow background for ALD operation, as illustrated in **Figure 2**.

Using a neutral carrier gas (that is distinct from the purge gas) precursor injections are carried out to move the precursor chemicals into the purge stream. That is, precursors are introduced to the purge stream from their respective sources 106, 108 via valves 116 and 118, respectively. This is done alternately and sequentially in time.

The condition for the injection into the purge stream at valve 116 (or 118) is established by the pressure value set just above the upstream position of valve 116 (or 118) by controller 117 (119). This allows precursor injection or blending into the purge gas stream on either side of the manifold 102. At the input 128 to the chamber, the two precursor lines open below the entrance to the reactor (forming multi-injects).

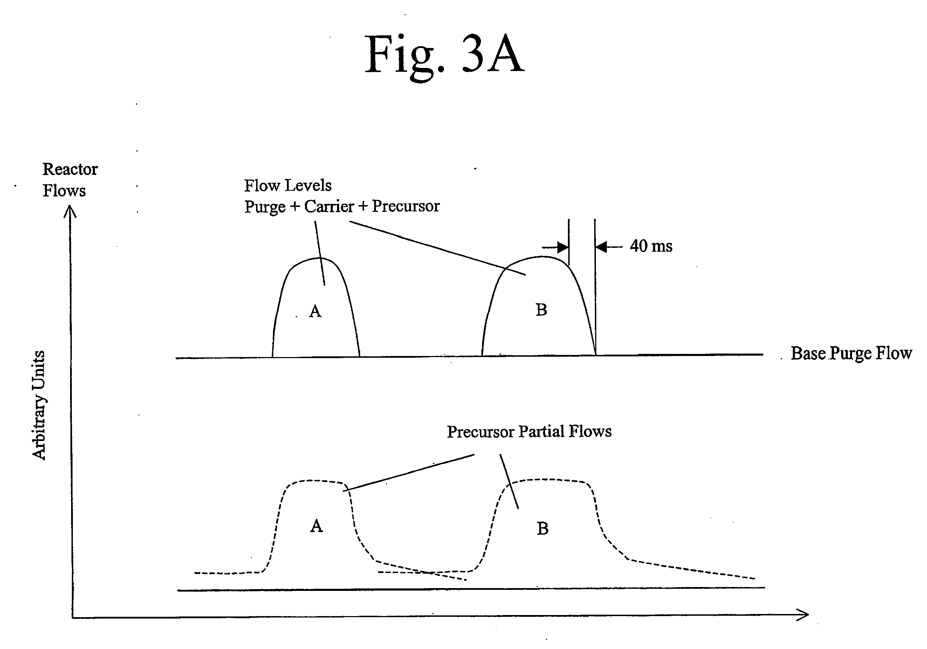

Once the flows of the carrier with precursor join the baseline purge flow, the overall flow in the reactor 110 will increase. If the carrier flow is small relative to the purge, which may be (and often is) the case, the increase in total flow and increase in reactor pressure will be small, but nevertheless observable, as shown in **Figure 3A**. One reason for this pressure rise above the baseline value may be that the response time of the throttle valve 120 is long compared with that of the injection valves 116, 118. That is, the inertia of the throttle valve 120 may lead to fluctuations in the reactor pressure during the purge period. Typical response times for injection valves 116 and 118 may be on the order of 20 - 30 msec, whereas response times of a typical downstream throttle valve 120 may be on the order of 500 -1000 msec (though throttle valves having response times of less than 100 msec have recently become available). Thus, the pressure in the reactor 110 may rise in coincidence with the increased flow.

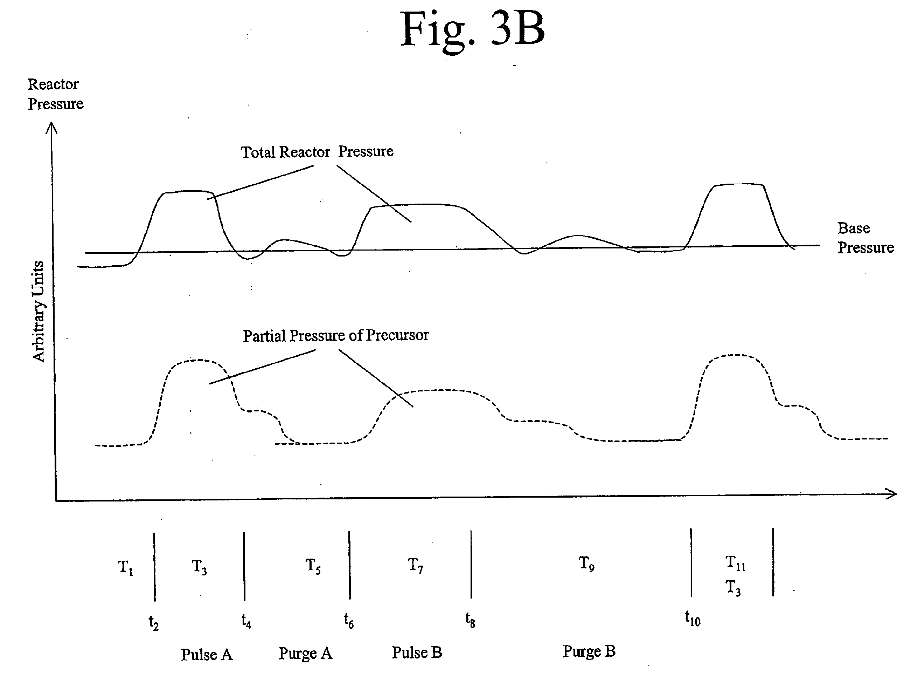

In fact, the pressure in the reactor 110 may change and fluctuate above and below that of the baseline flow level both during and after the period of the exposure pulse as shown in **Figure 3B**. Typically, the total reactor pressure is maintained during the middle and towards the end of the purge half-cycle, where the precursor's partial pressure is low enough to start the other precursor injection, because the throttle valve 120 and its closed-loop control system 122 have corrected to reestablish the desired reactor pressure. A well-designed system will exhibit a smooth decay of pressure vs. time.

Having thus described a state of the art ALD processing system, we turn now to a discussion of the present invention. As indicated above, the present invention makes use of a time-phased, multi-level flow to vary precursor residence time during ALD processes. Residence time is defined as the time it takes for a molecule of a reactant gas to move through a space (e.g., the reactor chamber) with a certain volume. If the pressure of the reactant gas is p, the volume of the space is V, and the flow rate is F, then the residence time r.t. is given by r.t. = pV/F. For example, if p = 200 mTorr (0.2/760 Atm), V = 1000 cm$^3$, F = 200 sccm (3.33 cm$^3$/sec), then r.t. = 0.079 sec = 79 msec. Alternatively, or in addition, residence time may be expressed in terms of the reactor volume (V) and the effective pumping speed (S) at the orifice where the precursor is removed from that volume: r.t. ~ V/S.

During reactant exposure times (a.k.a. pulse times, which, historically, have been of the order of or greater than a few hundred msec), it is desirable to have long residence time (e.g., to conformally coat high aspect ratio devices). Since the reactor chamber volume and pressure are relatively constant, and the residence time is inversely proportional to the flow rate, in order to achieve longer residence time, lower flow rate is necessary. However, long residence time is not desirable during the reactant removal time (purge time) because a longer residence time means a longer purge time. In order to achieve shorter residence time, higher flow rate is necessary. Therefore, there is a conflict between the needs of reactant exposure and reactant removal.

The present invention's use of a time-phased, multi-level flow overcomes this conflict by using different purge flow rates so that residence time of reactant molecules can be optimized in different periods of an ALD cycle. By doing so the overall ALD cycle time is reduced (over that required by conventional systems), allowing for greater wafer throughput. Importantly, the present invention achieves this advantage while at the same time not requiring the use of a continual, high flow purge which tends to be wasteful. Indeed, if the purge flow were simply increased over the entire ALD cycle, then the precursor would be driven out of the reactor chamber too fast during the exposure times and this adversely increases the exposure time. By using a relatively low flow rate during precursor exposure the present invention may, in some embodiments, actually allow for shortening the pulse time further helping to decrease the overall ALD cycle time.

In addition to using time-phased, multi-level flow, some embodiments of the present invention utilize different purge gasses during the different ALD half-cycles. That is, a different purge gas may be used during the purge period than is used during the exposure period. To understand the rationale for this use of different purge gasses, consider the following. The collision theory of hard sphere may be used to estimate the number of collisions per unit volume per unit time for the purge gas "P" on the precursor "A" or "B." See, e.g., K.J. Laidler, Chemical Kinetics, pp. 81-87 (1987). For two unlike molecules, the collision rate is:

$$N_P \; x \; N_A \; x \; r^2 \; x \; (kT/m^*)^{1/2}.$$

Here $N_P$ is the concentration of purge gas, $N_A$ the concentration of precursor gas "A" and m* is the effective mass ($m_A m_p / m_A + m_p$) of the purge and precursor molecules. This indicates that a higher concentration of purge gas density increases the collision rate and increases the forward momentum for removing the precursor gas. Although the collision rate is higher as the effective mass is lowered by $1/\sqrt{m^*}$, the transferred momentum to the precursor gas is linear in the mass of the neutral purge gas molecule, so the choice of purge gases favors heavier masses by the square root of m*. In this respect, Ar with atomic mass 40 may be more favorable than $N_2$ with atomic mass 28. Thus, in some embodiments of the present invention Ar is used during the purge period, while $N_2$ may be used as an independent control gas during the exposure period to lower gas usage costs.

Finally, embodiments of the present invention provide for maintaining the reactor pressure nominally constant. Such a condition is desirable during ALD (and CVD) processes because it helps to keep particle contamination within the reactor chamber to a minimum. To understand why this is so, consider that all chemical deposition techniques are accompanied by parasitic deposition on the walls and surfaces of the reactor. After a certain total thickness and accumulation, the deposits flake off due to stress effects and provide secondary, macro-particle contamination. These particles may be up to microns in size (distinguishing them from much smaller, sub-micron sized particles caused by gas phase nucleation). Large variations in pressure within the reactor can result in the premature flaking off of these particles, a situation that aggravates the maintenance of the deposition reactor. Although there is no well-defined range over which reactor pressure must controlled in CVD or ALD processes, an empirically defined range of operational pressures acceptable for film deposition suggests a "substantially constant pressure" of approximately 1 - 3 times the baseline operating pressure may be suitable, but variations of pressure greater than five times the baseline pressure may be unsuitable (though in some cases such operation may be desirable to break turbulence that helps to eliminate precursors that may have become trapped in the reactor chamber).

In one embodiment of the present invention then, an ALD reactor is controlled at a nominally constant pressure using a closed loop feedback controlled, or a command controlled open loop downstream throttle valve. By maintaining an acceptable, substantially constant pressure for the reactor, secondary, macro-particle contamination is minimized. If the flow rate of the purge gas is rapidly reduced to a low value, the throttle valve will move (at least initially) to a more closed position, which results in a longer residence time for the precursor in the reaction chamber. This is desirable during the pulse time, but undesirable during the purge time. Consequently, the present invention incorporates a bi- or multi- level purge flow capability in addition to the throttle valve. If two purge flow levels (low and high) are used, the low purge flow is used during the exposure pulse (allowing for a relative increase the precursor exposure and increased chemisorption and chemical utilization in a given time) and the high purge flow is used during the purge (to reduce residence time of the residual precursor); providing an advantageous situation for both the exposure and purge half-cycles.

More generally, the present invention provides several alternative embodiments for the operation of time-phased, multi-level flow (TMF) ALD processes. One such method includes the use of two or more downstream pumps (or pump capacities if a single pump is used), switched substantially in time-phase with two or more upstream purge flows (e.g., between low and high levels). This method may be used in either of two modes: mode I, without the second pump (pump capacity) to allow longer residence time during a lower flow level purge; or mode II, with the second pump (or pump capacity) switched on during the higher flow level purge. The pressure can be maintained nominally constant if the higher-level flow is matched to the pumping capacity of the combined pumps (or higher pumping capacity if a single pump is used).

In a second method, the purge flow is controlled by switching upstream, flow-limiting conductances (e.g., from a low to a high value for low and high flow, respectively) in time-phase with downstream conductances (e.g., from a low to a high level for low and high flow, respectively). This method is referred to herein as "tracking conductance(s)" in the system. This approach provides not only the ability to keep the pressure of the reactor nominally constant (as long as the fraction of upstream and downstream conductances are the same at any point in time during the switching cycle), but also allows for a wide dynamic range of purge flows. The upstream switching conductances may be placed in a variety of configurations: for example, in series with or imbedded within a split-flow chemical manifold, or in parallel with the chemical delivery manifold lines. The downstream switching conductances may also be placed in a variety of positions: for example, in the locale of the first downstream constriction just downstream from the reaction zone, or integrated as part of the downstream throttle valve (which in this case is controlled independently so as to assume designed positions or openings and is not used in a closed loop control mode).

In a third method, a separate purge gas control line (which may also be called a direct-coupled conduit or DCC) independent of the chemical sourcing in the split-flow manifold, is fed into the reactor pump stack either above the throttle valve or below the throttle valve, or into the first constriction leading from the reaction space. Using this path an independent control gas flow level may be set with an independent pressure regulator. The source may be an independent gas type (e.g., $N_2$ or He) relative to that used as the main ALD reactor purge (e.g., Ar). This independent purge gas control line may also be asynchronously timed relative to the period of the end of the exposure pulse (ahead of the period of the desired action), providing flexibility for optimizing the multi-level flows. The independent higher temperature control of this line also provides better purge capability without promoting the decomposition of precursors with low decomposition temperatures.

Generally, the DCC may either pass parallel to the split-flow manifold, or be part of an ALD system that has all its sources directly coupled to the reactor. Thus, the multi-level flow purge gas may pass in parallel to the chemical sourcing or serially through it. To demonstrate the idea, a second neutral-purge conduit line can be added to the apparatus with appropriate fast gas switching valve arrangements. A residual gas analyzer may be used to detect how precursor concentrations change. Tf the valves that control the purge lines are quite far away from the chamber, the response time may be unfavorably long (e.g., a couple of seconds). To minimize this problem valves may be placed suitably close to the chamber and /or larger diameter purge lines may be used between the upstream pressure sources and the chamber. All the controlling valves may be integrated into a common hub or block, ensuring minimal response time, as may be known in the art.

To achieve the multi-level purge methods described above, an ALD apparatus 400 having a second purge conduit that is introduced upstream of the chemical gas switching manifold and in parallel with the first purge conduit is provided. This arrangement (which may be termed a dual flow purge manifold 403) is illustrated in **Figure 4**. Both purge sources may be pressure controlled (e.g., using pressure controllers 409 and 411) with set points of pressure that can be widely different. Given the current state of the art, the pressure controllers 409 and 411 cannot be fast gas switched below several hundred milliseconds (however, future pressure controllers may allow for direct, fast electronic control). We avoid this shortcoming by passing the pressurized gas through fast switching pneumatic valves (with conductances determined by the conduit lines, elbows, valve and any restrictor components in the lines between the pressure sources 409/411 down to and including the entrance 428 to the reactor 410). This implementation has each purge conduit leading to switching valves 405 and 407. These valves may be as fast (e.g., on the order of 20 msec) as are used for precursor injection valves 416 and 418.

Within the dual flow purge manifold 403, valve 405 may be configured to actuate below a relatively low pressure suitable for use during the exposure pulse. Valve 407, on the other hand, may be configured to actuate below a relatively high pressure, suitable for use during the purge period. The precise timing for these valves to be switched on and off may be in a range of times around 10 - 30 msec. The turn-on and turn-off times may not need to be nor want to be coincident with the turn-on and turn-off times of the exposure pulses. This allows for reliable software control for optimizing and minimizing the time between actual switchover between the exposure and purge flows within the reactor chamber 410. This is discussed further below, in developing the concept of optimal time-phased, multi-level flow using asynchronous flow concepts.

The ALD apparatus 400 also has provision for a second pump 432 placed at a downstream location along with the first system pump 430. Pump 432 can be switched into operation by opening valve 434 at a time substantially coincident with the turn-on of the upstream, higher-pressure valve 407. The two pumps described here can be two physical pumps or two fractions of the pumping capacity of a single physical pump. The latter is referred to as virtual pump. If the conductance of valve 434 is appropriately selected the result can be the maintenance of nominally constant pressure during the entire ALD cycle.

Operation with this two level ALD purge apparatus 400 may be carried out advantageously in many modes, some of which are illustrated in the following tables. The time elements reflected in the tables represent either a particular period, $T_x$, or a particular instant, $t_x$, in time. Graphical illustrations of these time periods and instances are reflected in Figure 3B, however, the illustration of reactor pressure in the figure is not necessarily meant to correspond to the operational conditions reflected in the tables.

Operation Mode I: non-constant pressure. In this mode of operation (illustrated in Table 1), the downstream throttle valve 420 may be set at a fixed position: e.g., at a position corresponding to a desired reactor baseline pressure, or may be fixed as fully open (o). The switching on of the upstream higher-level pressure through valve 407 may result in excursions of pressure in the reactor chamber 410 in the time frame of the pulse-purge operations. In this mode pump 432 is not used and valve 434 is closed (c).

Table 1: Operation at Non-constant Pressure

| Time: | $T_1$ | $t_2$ | $T_3$ | $t_4$ | $T_5$ | $t_6$ | $T_7$ | $t_8$ | $T_9(T_1)$ | $t_{10}(t_2)$ |
|---|---|---|---|---|---|---|---|---|---|---|
| Function: | Purge B | | Expose A | | Purge A | | Expose B | | Purge B | |
| Valve 416 | c | o | o | c | c | c | c | c | c | o |
| Valve 405 | c or o | o | o | c | c or o | o | o | c | c or o | o |
| Valve 418 | c | c | c | c | c | o | o | c | c | c |
| Valve 407 | o | c | c | o | o | c | c | o | o | c |
| Valve 434 | c | c | c | c | c | c | c | c | c | c |

Operation Mode II: nominally constant pressure. Here, the downstream throttle valve 420 may be set to a fixed position: e.g., at a position corresponding to a desired reactor baseline pressure, or may be fixed as fully open. As illustrated in Table 2, the switching on of upstream, higher level pressures through valve 407 and the action of the downstream throttle valve 420 for switching into pump 432 via valve 434 may ensure that a correction towards or to the baseline reactor chamber pressure occurs in the time frame of the pulse-purge operations.

Table 2: Operation at Nominally Constant Pressure

| Time: | $T_1$ | $t_2$ | $T_3$ | $t_4$ | $T_5$ | $t_6$ | $T_7$ | $t_8$ | $T_9(T_1)$ | $t_{10}(t_2)$ |
|---|---|---|---|---|---|---|---|---|---|---|
| Function: | Purge B | | Expose A | | Purge A | | Expose B | | Purge B | |
| Valve 416 | c | o | o | c | c | c | c | c | c | o |
| Valve 405 | c or o | o | o | c | c or o | o | o | c | c or o | o |
| Valve 418 | c | c | c | c | c | o | o | c | c | c |
| Valve 407 | o | c | c | o | o | c | c | o | o | c |
| Valve 434 | o | c | c | o | o | c | c | o | o | c |

Additional configuration variations or combinations for different operational modes can, of course, be used. One such configuration would be the passage of inert purge gas directly to the reactor (using an appropriate timing sequence) and run in parallel to by-pass the precursor-switching manifold 402. The flow of the additional purge gas can be increased during the purge step to provide for increase in the total flow and thus decrease the purge time. This gas can be delivered through a specially designed gas manifold for optimal purge efficiency.

Variants on the design illustrated in Figure 4 include an ALD apparatus having a pump and connecting valve (in place of or in addition to pump 432 and valve 434) that are connected to the pump stack above the throttle valve 420. Such an arrangement may permit more efficient pumping. The valve may be a parallel array of large diameter pneumatic switching valves, or a fast switching (e.g., on the order of or less than 100 msec) throttle valve.

Another variant includes a high flow purge source that is directly and independently connected to the rector 410. This high flow purge source would be independent of and parallel to the chemical switching manifold 402. In this case the independent purge source (which may include multiple purge flows) may be either the high or low flow, the other being the purge taken from the chemical switching manifold 402.

With reference to the direct-coupled conduit (DCC) method described above, one embodiment of an ALD apparatus 500 implementing such a conduit is shown in **Figure 5**. Here, the conduit 536 runs in parallel to bypass the split-flow manifold 502 in a manner that allows purge switching by valve 538. This high flow purge line is  independent of the main purge line through the chemical switching manifold, which can be one or both of lines from pressure sources 509 and 511. Such an independent line may be used to limit the pumping speed during the exposure downstream to affect the effective pumping speed of the pump in the reactor zone. The high flow is driven by pressure controller 540 and actuated by valve 538 during the purge. The precursor chemicals may be injected with or without carrier gas and also with or without neutral gas from the purge, if valves 516 and 518 are closed during the exposure part of the cycle.

In alternative embodiments, a DCC may be run from the downstream side of valve 507 (or 505) directly to the reactor 510, bypassing (or not bypassing) the split-flow route. Or, where a non-split-flow manifold is used, independent precursor conduits may feed the ALD reactor and a DCC may be run in parallel therewith. In such a case, the DCC purge may be differentiated from the other lines feeding the reactor chamber by virtue of it containing only a high level of neutral gas flow during the purge periods, and/or by its relatively large conductance to promote purging of the reactor chamber relative to the precursor feed lines.

In still another embodiment, the DCC itself may be modified to permit two-or multi-level flow control (e.g., by replacing pressure controller 540 and valve 538 with a split- or multi-source manifold). In such an embodiment, a lower flow level via the DCC 536 may be used during exposure and a higher one during purge. In this configuration, either or both chemical precursors may be run without neutral gas dilution.

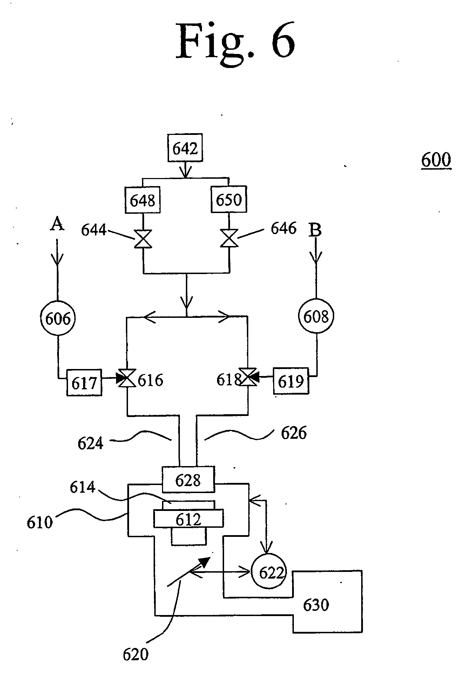

Another embodiment, shown in **Figure 6**, may be used to implement the tracking conductances approach referred to above. In ALD apparatus 600, the upstream purge pressure is common and fixed, using pressure controller 642. By switching (e.g., via valves 644 and 646) the upstream flow through two different limiting conductances (e.g., metering valves) 648 and 650, having low and high conductance values, respectively, the overall purge flow (low or high, respectively) may be set. The low and  high flows are substantially switched in time phase with the downstream conductances from a low to a high level (for low and high flow, respectively). This approach provides the ability to keep the pressure of the reactor nominally constant as long as the fraction of upstream and downstream conductances are the same at any point during the switching cycle. Certainly this will be the case at the steady state set points of the exposure and purge periods. This solution provides both a wide dynamic range of purge flows as well as a design constrained to operate at nominally constant pressure.

The reactor pressure for a reactor of very large conductance (compared with the conductances in line from source 642) placed in series between an upstream flow limiting conductance and downstream flow limiting conductance can be approximated by an expression for the chamber pressure:

$$P_{cham} \sim {}^{u}P \ x \ [(1/{}^{d}C) \ / \ (1/{}^{d}C + 1/{}^{u}C)] \qquad\qquad (1),$$

where ${}^{u}P$ is the upstream pressure that may be set with a pressure controller, and ${}^{d}C$ and ${}^{u}C$ are the downstream and upstream conductances, respectively. The reciprocal conductances are proportional to the flow impedance, so at any constant flow the chamber pressure is just the ratio of pressure drop across the downstream impedance to the total impedance.

This model is used to write Eq. 1, and is analogous to that provided by an electrical circuit, with constant supply voltage Vs (analogous to the upstream pressure), and upstream series resistance, Ru (analogous to the upstream reciprocal conductance) and node voltage below Ru (analogous to the chamber pressure), a downstream resistance (analogous to the downstream reciprocal conductance) and a ground (analogous to the downstream pump). In this linear equivalent circuit, the node voltage is given by:

$$Vs \ x \ [Rd \ / \ (Rd + Ru)].$$

A key difference in the gas stream case is that the conductance elements may not be operating in a linear range with respect to their dependence on pressure. Nevertheless, regardless of the functional form of the pressure drop across the conductances, such a proportionality can be used.

The upstream pressure is typically approximately several 10s to 100 Torr and the chamber pressure is approximately 100 mTorr to 1 Torr. Thus the typical impedance ratio, downstream to total, is a factor of 10 - 100. ALD apparatus configured in accordance with the present invention typically provide flow rates for ratios in a range of up to approximately 100, though in some cases higher ratio values may exist because downstream impedance may be mainly determined by the position of the throttle valve (minimum) and pump capacity (maximum).

Considering the typical case then, the total impedance to flow must be able to be changed by a factor of approximately 100 or more. If the value of ${}^{d}C$ at its lowest value is approximately 101/s (downstream throttle valve near closed), the corresponding value of ${}^{u}C$ may be set by design to be approximately 0.51/s, providing a pressure drop of 21:1, but the flow is small and limited by the upstream restricting conductance. If the upstream pressure is 10 Torr, the chamber pressure will be 10/21 or approximately 500 mTorr and the flow is 10 x 0.5 Torr 1/s. This represents the condition of the flow and pressures when the flow is in a low state.

If the value of ${}^{d}C$ at its highest value is approximately 10001/s (downstream throttle valve near open), the corresponding value of ${}^{u}C$ may be judiciously set by design to be approximately 501/s, again providing a pressure drop of 21:1, and the flow is now large and limited by the upstream restricting conductance. If the upstream pressure is 10 Torr, the chamber pressure will again be 10/21 or approximately 500 mTorr and the flow is 10 x 50 Torr 1/s. This represents the condition of the flow and pressures when the flow is in a high state, which is 100 times the low state flow.

This example can be favorably generalized so that the pressure in the chamber remains nominally constant at all times in the ALD cycle. This can be done if the upstream and downstream conductances have factional values of their full range, which is always the same fraction:

$$P_{cham} \sim {}^{u}P \ x \ [(1/{}^{d}f \ {}^{d}C) \ / \ (1/{}^{d}f \ {}^{d}C + 1/{}^{u}f \ {}^{u}C)] \qquad\qquad (2),$$

where ${}^{d}f$ and ${}^{u}f$ are the fraction of the range of conductance of the downstream and upstream conductances, respectively. If the ratio of ${}^{d}f$ to ${}^{u}f$ (call it f) is always the same at any point in time and a common fraction f of the range of the conductance of the downstream and upstream valves or restrictors, the f values cancel in the expression and the pressure is canonically constant, $P_{cham} \sim {}^{u}P \ x \ [(1/{}^{d}C) \ / \ (1/{}^{d}C + f/{}^{u}C)]$.

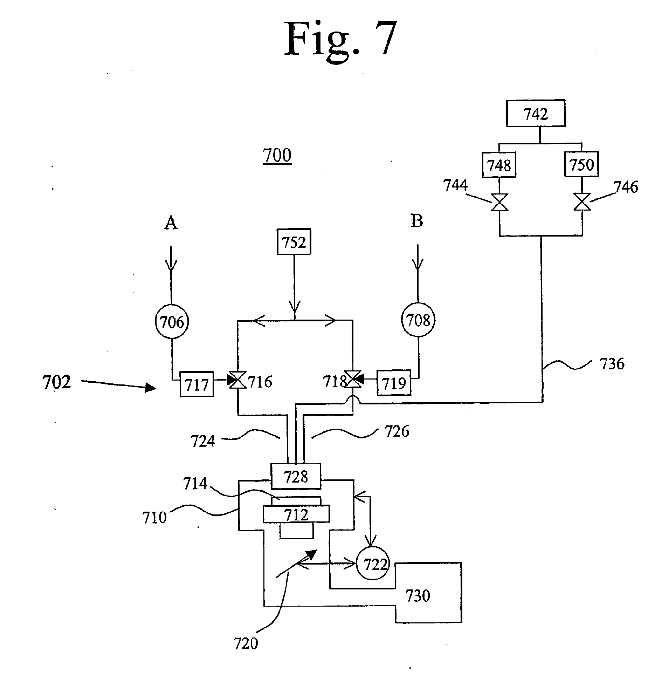

As illustrated in **Figure 7**, the tracking conductances approach can be implemented using a DCC 736. The DCC gas pressure level may be set with an independent pressure regulator 742 and the source may be an independent gas type (e.g., $N_2$ or He) relative to that used as the main ALD reactor purge (e.g., Ar) from source 752. The tracking conductances 748 and 750 may be set for low (exposure) and high (purge) flow, respectively. The switching valves, 744 and 746, may be set for low and high flows substantially coincident with the setting of the downstream conductance of the throttle valve 720 to achieve nominally constant pressure during exposure and purge.

The matching of the ratio of upstream and downstream conductances (tracking conductances) is designed to achieve a low flow during the exposure, corresponding to high residence times, and a high flow during precursor removal or purge, for low residence times. By maintaining constant (or nearly so) the ratio of the conductances, substantially constant pressure in the reactor is achieved. An alternative method to achieve constant pressure, but still with different flows, is to use independent, directly coupled conduit lines. A first gas line may inject a purge flow at level "Fp" directly into the reaction space, and a second independent (separate) line directly coupled downstream from the reaction space may provide an appropriate flow level "Fe" to the pump. The upstream and downstream flow values are selected so as to provide for nominally constant pressure (e.g., within a range of +/- 50% of an average) to be achieved in the reactor during the periods of purge and exposure. In the case where small flow limiting conductances exist between the downstream injection position and the reaction space, the flows may be substantially the same. The upstream purge may be selected to enhance entrainment of the precursor reactant for its removal. For example, Ar (having a relatively heavy mass) may be used to maximize the entrainment during purge. Heavier neutral gases (Kr, Xe, etc.), although more efficient as entrainment gases, are likely too expensive to use in commercial reactors. The downstream purge may be selected to reduce cost as it is not active during the purge, and $N_2$ is the gas of choice (He being more expensive that $N_2$).

Another alternative is to route the independent gas control line to provide a flow to the pump 730 that reduces the effective pumping speed on the reaction chamber 710 during the exposure time, thus increasing the residence time of precursors therein. In such an apparatus, the DCC line 736 would be routed to the zone between the throttle valve 720 and the pump 730, rather than to the reactor 710.

In one embodiment, ALD apparatus 700 may allow for a multi-level flow source having an upstream regulated inlet pressure of 35 Torr, leading into a split-flow manifold. The split-flow manifold may have a low flow branch set at 10 sccm as determined by a metered needle valve (e.g., type SSVR4) with a Cv of .005 - .03 and high flow branch set at 1000 sccm as determined by a metered valve (e.g., type SS-4BMRC-VCR) with a Cv of .05 to .3. The low flow branch may have a fast switching pneumatic valve (e.g., type Veriflo 955AOLP, Cv = .55) positioned upstream of the needle valve. The purge flows may be input to the reaction zone (which may be at 200 mTorr) of the reactor independently of the A and B chemical supply flow line(s). Specifically, the purge flows may pass through a gas distribution module which has a flow coefficient (Cv) of more than 70 and which does not result in significant pressure drop, and from there through a perimeter orifice annulus (which has a Cv of more than 150) beyond the wafer perimeter to the lower part of the reactor vessel. From the reactor vessel the gas path may be to and through a restriction set by a fast switching pressure control throttle valve (e.g., type VAT 61 with a 4" throat), leading to a 6" diameter foreline to a rough pump (e.g., type BOC Edwards iH1800) that can maintain gas flows well above 2000 sccm with a reactor pressure of 200 mTorr. The controllable conductance range for the throttle valve is 1 to 14001/s. For such a system, a flow of 100 sccm at a reactor pressure of 200 mTorr will require a conductance of 6.31/s and a flow of 1000 sccm will require a conductance of 631/s, both well within the range of the throttle valve.

The independent purge line provides the flexibility to optimize the minimization of exposure time. If the DCC switching is started ahead of the actuation of the exposure time by a time, dt, the effective pumping capacity at the point of the exit orifice to the reaction volume can be time-phased to be coincident with the arrival of precursor into the reaction volume. In this way, the delay of the reduced pumping speed arriving at the reaction chamber is matched with the arrival of the precursor through the upstream switching manifold. dt is given by the residence time of the precursor gas between the injecting valve and the reaction chamber and includes the conductances of connecting lines, orifices and distribution module (e.g., showerhead components). We refer to this method as asynchronous timing (AT) for optimizing the edges of the expose and removal periods in the cycle time. AT can be applied with any of the methods or apparatus of the present invention described herein.

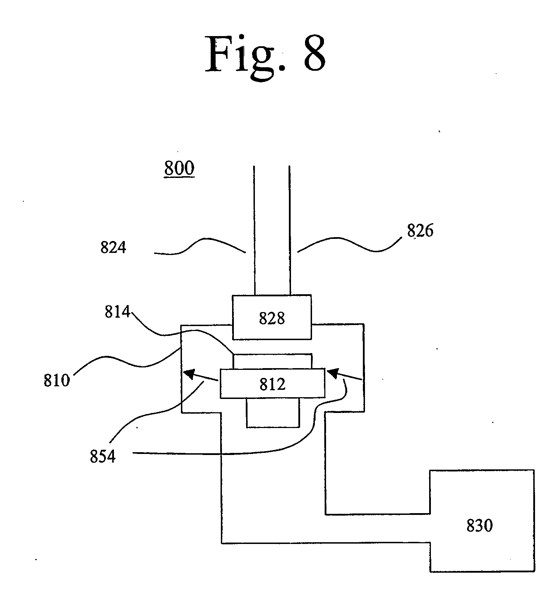

In still another embodiment, the tracking conductance approach may be implemented using an annular throttle valve (ATV) 854, as illustrated for the ALD apparatus 800 shown in Figure 8. ATV 854 is used to adjust the conductance of an annular gas flow pathway in the reactor 810 so that the gas flow rate through the reactor can be adjusted. Recall that the residence time (r.t.) of a molecule in a space with volume V and flow rate F is given by r.t. = pV/F. When ATV 854 is open, it provides high conductance (i.e., high flow rate). Therefore the residence time of the reactant molecules is short. When an ATV 854 is closed, it provides low conductance (i.e., low flow rate). Therefore the residence time of the reactant molecules is long. Thus, by adjusting the ATV (e.g., between a fully open position and a fully closed position, or any positions therebetween) the residence time or the precursors can be adjusted according to different needs in exposure time and removal time.

This approach places a fast switching (e.g., less than or the order of 100 msec), limiting conductance as close to the reaction space as possible. This provides the advantage of sharp residence time control, with minimal precursor backflow. That is, little or no precursor will flow through the low conductance state of the ATV and the effect on residence time will be felt with minimum delay.

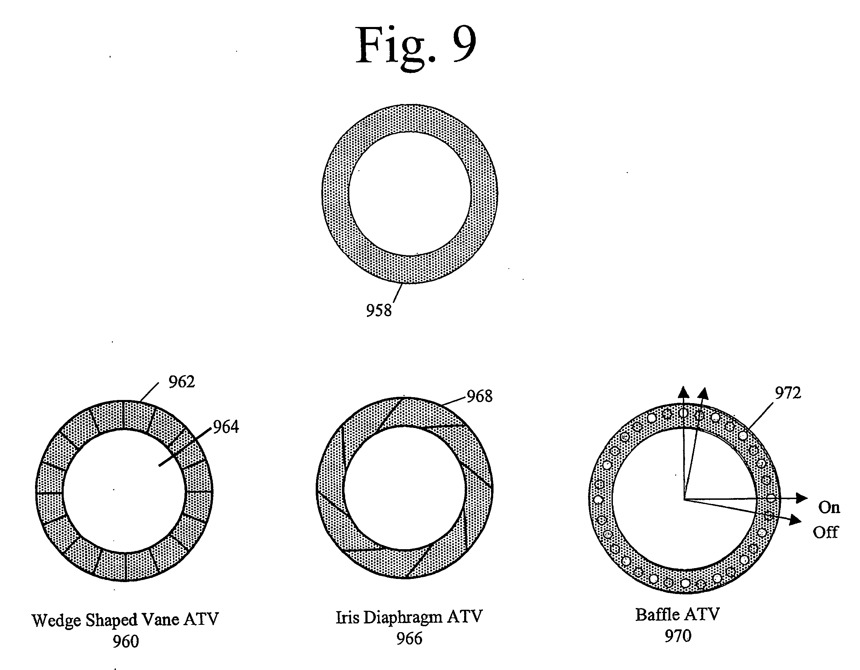

The ATV 854 of the present invention is a throttle valve that adjusts the conductance of a conduit with annular cross section. An ATV's conductance can be adjusted (e.g., opened, closed or moved to a position therebetween if more than just discrete modes are provided) electrically, magnetically, mechanically, pneumatically or by another method. An ATV can be adapted to any convenient opening/closing configuration, and several examples of such configurations are shown in **Figure 9**. Each of these ATVs is designed to provide varying conductances through an opening 958 having an annular cross-section.

In a first example, a wedge-shaped vane ATV 960 provides a means of continuous conductance adjustment.

This ATV has multiple wedge-shaped vanes 962, each of which can rotate about its axis 964 (which in the illustration lies in the plane of the page). When the plane of a vane is parallel to the plane of the wafer holder (susceptor), the vane is in its fully closed position. When all of the vanes (which may be independently controlled) are in this position, the ATV 960 is in its fully closed position and the conductance of the conduit is at minimum. When the plane of a vane is perpendicular to the plane of the wafer holder, it is at its fully open position. When all of the vanes are in this position the ATV 960 is fully open and the conductance of the conduit is at maximum. By varying the number of fully open or fully closed vanes, the conductance of the conduit can be adjusted from its minimum (all vanes fully closed) to its maximum (all vanes fully open). Of course, it is possible to implement vanes that can assume positions other than fully open or fully closed so as to provide a 'fine tuning' ability in terms of regulating the conductance of the conduit. In general, a vane's weight and momentum of inertia should be minimized to allow for a fast response time.

In a second example, a camera shutter (or iris diaphragm) ATV 966 also provides a means of continuous conductance adjustment. This ATV has multiple blades 968 that move in the plane that is nearly parallel to the plane of the susceptor. It imitates a camera shutter movement except that a camera shutter closes from a certain diameter to zero diameter position while this ATV closes from the position of the outer diameter of the ring to the position of the inner diameter of the ring. The inner diameter of the ring usually is very close to the diameter of the susceptor. The conductance of the conduit can be continuously adjusted when the blades of camera shutter ATV 966 move from a fully open position to a fully closed position.

The third example in the illustration shows a baffle ATV 970 which allows for two-state (open & closed) operation. This ATV consists of two identical annular pieces or blades, one on top of the other, with a group of holes 972 within each of them acting as conduits. When the holes of the two pieces coincide, gas can flow through the holes, and the ATV is said to be open. When the two pieces have an angular displacement with respect to one another such that none of the holes overlap, gas cannot flow and the ATV is said to be closed. By varying the annular displacement of the blades with respect to one another then, the conductance of the conduit can be turned on and off. If the displacement of the two blades can be controlled carefully so that the two groups of holes partly overlap with each other, the conductance can be continuously adjusted between a fully open and a fully closed state. Alternatively, or in addition, by varying the hole positions or increasing the number of blades (each possibly having different hole layouts and/or sizes) this form of ATV can be adapted to have three, four or more modes of operation, each of which will provide varying numbers (and perhaps sizes) of open holes (and, hence, varying conductance) to allow gas to pass therethrough.

Compared to a conventional throttle valve, an annular throttle valve is closer to the wafer, which makes chamber pressure response time shorter (due to the reduced volume above the valve). It also increases the efficiency of reactant usage. Compared to the "draw control chamber" method described by Sneh, an important advantage of an annular throttle valve is that it can prevent back diffusion to the reaction zone that interferes with the precursor distribution.

The ATV may be operated in a fashion very similar to that for the conventional throttle valve discussed above. In general, the ATV provides more efficient coupling with the upstream module that provides the time-phased multi-level flows. Table 3 illustrates some operational modes for an ATV.

Table 3: Operational Modes for ATV

|  | ATV position | Flow in chamber | Residence time |
| --- | --- | --- | --- |
| Exposure | Low Flow | Low | Long |
| Removal | High Flow | High | Short |

Thus, methods and apparatus for cycle time improvements in ALD processes have been described. In the foregoing discussion the invention has been described with respect to various illustrated embodiments thereof, however, it should be remembered that these descriptions were for convenience only and should not be read as limiting the broader scope of the invention. For example, although the methods and apparatus described above were discussed with reference to thermal ALD, they are equally applicable to plasma-assisted ALD. In such cases one of the precursors may first be exposed with no plasma, followed by a high flow level purge operation, then a plasma-assisted exposure of the second precursor may be followed by either no purge or a higher flow level purge. The benefit in cycle time improvement for the plasma-assisted process may be quantitatively less than that for the thermal ALD case because plasma-assisted ALD cycles may be run without a purge period following the plasma-assisted half-reaction. Although a plasma-assisted step at higher flow pressures may be advantageous in some applications. In addition, one may choose to operate the purge in a neutral plasma mode, if the plasma purging has no deleterious effect of the deposited film on the substrate/wafer. A suitably designed electrode configuration for use with active purging during plasma may result in a limited reaction and a better controlled surface reaction during surface precursor adsorption for improved film quality. Finally, certain variants of classical ALD developed by some of the present inventors concurrently with the methods and apparatus described herein, such as sub-saturation ALD (e.g., Transient Enhanced ALD and Starved Reaction ALD) can be further enhanced by the use of the present methods and apparatus. In these processes, the self-limiting ALD reactions are either designed to just reach the onset of saturation or not permitted to go to completion. Thus, the full scope of the present invention should be measured only in terms of the claims, which follow.

**Claims**

1. An atomic layer deposition (ALD) apparatus, comprising:

   a reactor chamber (410);
   a first purge flow pathway (405, 411) coupled upstream of the reactor chamber (410);
   means for providing a first purge flow flowing through the first purge flow pathway (405, 411) and a second purge flow which is greater than the first purge flow;
   means (416, 417; 418, 419) for performing a precursor injection into the reaction chamber (410) together with the first purge flow;
   means for switching the precursor injection means (416, 417; 418, 419) between an active-state during an expose period of an atomic layer deposition and a non-active-state during a purge period;
   wherein the second purge flow is injected into the reactor chamber (410) during the purge period; and
   a pumping arrangement (420,422,430) coupled downstream of the reactor chamber (410),

   **characterized**
   **by** a second purge flow pathway (407, 409) coupled upstream of the reactor (410) for the second purge flow;
   wherein the pumping arrangement (420,422,430) is configured to be switched between a first pumping capacity when the first purge flow pathway (405, 411) is active and a second pumping capacity greater than the first pumping capacity when the second purge flow pathway (407, 409) is active.

2. The ALD apparatus of claim 1, wherein the first and second purge flow pathways share a common gas flow manifold with one or more precursor injection pathways.

3. The ALD apparatus of claim 1, wherein at least one of the first and second purge flow pathways is directly coupled to the reactor independently of the other.

4. The ALD apparatus of claim 1, wherein the first and second pumping capacities comprise two operational modes of a single physical pump.

5. The ALD apparatus of claim 1, further comprising a throttle valve downstream of the reactor chamber.

6. The ALD apparatus of claim 5, wherein the second pumping capacity is provided, at least in part, by a physical pump coupled downstream of the reactor chamber but upstream of the throttle valve.

7. The ALD apparatus of claim 5, wherein the first and second pumping capacities are provided by one or more pumps coupled downstream of the throttle valve.

8. The ALD apparatus of claim 1, wherein the first and second purge flow pathways are configured to operate at first and second purge gas pressures, respectively, the first pressure being less than the second pressure.

9. The ALD apparatus of claim 8 , wherein the first and second purge flow pathways share a common gas flow manifold with one or more precursor injection pathways.

10. The ALD apparatus of claim 9, wherein at least one of the first and second purge flow pathways is directly coupled to the reactor independently of the other.

11. The ALD apparatus of claim 1, **characterized in that** the first and second purge flow comprise selectable upstream flow limiting conductance having two or more operational modes including a low flow mode and a high flow mode; and the pumping arrangement comprise selectable downstream flow limiting conductance having two or more operational modes including a low flow mode and a high flow mode, wherein the upstream flow limiting conductance and downstream flow limiting conductance are configured to switch operational modes in time-phase with one another.

12. The ALD apparatus of claim 11, wherein the upstream flow limiting conductance are configured to switch operational modes prior to the downstream flow limiting conductance switching operational modes.

13. The ALD apparatus of claim 11, wherein the downstream flow limiting conductance include a throttle valve.

14. The ALD apparatus of claim 13, wherein the throttle valve comprises an annular throttle valve located within the reactor chamber.

15. The ALD apparatus of claim 11, wherein the purge flow pathway comprises multiple gas flow pathways for purge gasses and chemical precursors which share one or more common inputs to the reactor chamber.

16. The ALD apparatus of claim 15, wherein at least one of the purge gas flow pathways is independent of the gas flow pathways for the chemical precursors.

17. The ALD apparatus of claim 1 **characterized by** a gas delivery system coupled to the reactor chamber having disposed therein an annular throttle valve positioned within a gas flow pathway from the reactor chamber to the pumping system coupled downstream of the reactor chamber.

18. The ALD apparatus of claim 17, wherein the annular throttle valve has two or more operating modes, each configured to provide a different flow path conductance from the reactor chamber.

19. The ALD apparatus of claim 18, wherein the gas delivery system is configured to provide purge flows at two or more flow levels.

20. The ALD apparatus of claim 19, wherein the annular throttle valve is coupled to a control system configured to switch operating modes of the annular throttle valve according to a level of purge flow so as to maintain a nominally constant reactor chamber pressure.

21. The ALD apparatus of claim 17, wherein the annular throttle valve includes multiple vanes, each having an axis there through about which an individual vane rotates from a first position to a second position.

22. The ALD apparatus of claim 17, wherein the annular throttle valve includes multiple blades arranged in an iris configuration.

23. The ALD apparatus of claim 17, wherein the annular throttle valve includes multiple blades, each having a number of holes there through, at least one of the blades being rotatable about an axis such that holes extending through the rotatable blade align with holes of at least one of the other blades to provide a passage through the annular throttle valve.

24. An ALD apparatus of claim 1, characterized a first neutral gas line configured to inject an Ar gas flow level into are action space during a purge period of an ALD cycle, and a distinct, second neutral gas line configured to inject an N2 gas flow level downstream of the reaction space, the gas flow levels being selected so as to provide for substantially constant pressure in the reaction space.

25. A method for an atomic layer deposition (ALD) using an apparatus of one of the preceding claims performing an expose period in which a precursor is injected into the reaction chamber (410) together with the first purge flow flowing through the first purge flow pathway (405, 411) coupled upstream of the reactor chamber (410) at a first pumping capacity of the pumping arrangement; and
a purge period wherein a second purge flow greater than the first purge flow is injected into the reaction chamber (410) without the precursor; **characterized in that**
the second purge flow flows through the second purge flow pathway (407,409) coupled upstream of the reactor chamber (410) at a second pumping capacity greater than the first pumping capacity.

26. The method of claim 25, further comprising maintaining a pressure of a reactor chamber within which the ALD process is performed nominally constant during the expose period and the purge period.

27. The method of claim 26, wherein the pressure of the reactor chamber is maintained nominally constant through operation of a throttle valve downstream from the reactor chamber such that the throttle valve is more open during the purge period than during the expose period.

28. The method of claim 25, wherein the first purge flow and the second purge flow comprise different gasses.

29. The method of claim 25, wherein the second purge flow and second pumping capacity are activated prior to termination of material deposition during the expose period.

30. The method of claim 25, wherein the second purge flow and second pumping capacity are activated so as to break existing turbulence within a reactor chamber within which the ALD process is performed.

31. The method of claim 25, further comprising performing a second expose period of the ALD process using a third purge flow and a third pumping capacity different from the first purge flow and first pumping capacity, respectively.

32. The method of claim 31, wherein the third purge flow comprises an absence of a purge flow.

33. The method of claim 25, wherein the expose period comprises a plasma-assisted process.

34. The method of claim 25, wherein the first purge flow is switched to the second purge flow at a substantially coincident point in time as the first pumping capacity is switched to the second pumping capacity.

35. The method of claim 34, wherein the first purge flow is switched to the second purge flow prior to completion of material deposition during the expose half-cycle.

36. The method of claim 25, wherein the first purge flow is switched to the second purge flow at a different point in time than that at which the first pumping capacity is switched to the second pumping capacity.

37. The method of claim 36, wherein the first purge flow is switched to the second purge flow before the first pumping capacity is switched to the second pumping capacity.

38. The method of claim 36, wherein the first purge flow is switched to the second purge flow after the first pumping capacity is switched to the second pumping capacity.

39. The method of claim 25, wherein the first purge flow is switched to the second purge flow by switching first flow limiting conductance located upstream of a reactor chamber within which the ALD process is performed out of a first gas flow path to the reactor chamber at a substantially coincident point in time as second flow limiting conductance located downstream of the reactor chamber are switched out of a second gas flow path from the reactor chamber.

40. The method of claim 25 wherein using the first purge flow defined in part by a first conductance of an annular gas flow pathway within the reactor chamber in which the ALD process takes place, and the second purge flow defined in part by a second conductance of the annular gas flow pathway within the reactor chamber.

41. The method of claim 40, further comprising maintaining a pressure of the reactor chamber nominally constant during the first period and the second period.

42. The method of claim 40, wherein the first purge flow and the second purge flow comprise different gasses.

43. The method of claim 40, wherein the first purge flow and the second purge flow are provided through different flow paths.

44. The method of claim 40, wherein the second purge flow is activated prior to termination of material deposition during the first period.

45. The method of claim 40, further comprising performing a third period of the ALD cycle using a third purge flow defined in part by a third conductance of the annular gas flow pathway and different from the first and second purge flows.

46. The method of claim 45, wherein the third purge flow comprises an absence of a purge flow.

47. The method of claim 40, wherein the first period comprises a plasma-assisted process.

48. The method of claim 25, wherein the first purge flow is switched to the second purge flow in part by switching first flow limiting conductance located upstream of the reactor chamber out of a first gas flow path to the reactor chamber at a substantially coincident point in time as the second conductance of the annular gas flow pathway within the reactor chamber is switched into a second gas flow path from the reactor chamber.

49. The method of one of the preceding claims wherein the first purge flow at a first pressure, the first purge flow passing through a first flow limiting conductance located within the first gas flow pathway upstream of the reactor chamber within which the ALD process is performed and a second flow limiting conductance located within the second gas flow pathway downstream of the reactor chamber, and performing the purge period of the ALD process using the second purge flow, the second purge flow passing through a third conductance located within the first gas flow pathway and a fourth conductance located in the second gas flow pathway, wherein a ratio of the first conductance to the second conductance is equal to a ratio of the third conductance to the fourth conductance and a pressure of the reactor chamber is maintained nominally constant during the ALD process.

50. The method of claim 49, wherein a second purge gas used for the second purge flow is different from a first purge gas used for the first purge flow.

51. The method of claim 49, wherein the expose period comprises a plasma-assisted process.

52. The method of claim 49, wherein the first purge flow is switched to the second purge flow at a substantially coincident point in time as the first conductance within the first gas flow pathway is switched to the third conductance.

53. The method of claim 49, wherein the first purge flow is switched to the second purge flow prior to completion of material deposition during the expose period.

54. The method of claim 49, wherein the first purge flow is switched to the second purge flow at a different point in time than that at which the second conductance in the second gas flow pathway is switched to the fourth conductance.

**Patentansprüche**

1. Vorrichtung zum Abscheiden atomarer Schichten (ALD), aufweisend;
   eine Reaktorkammer (410);
   eine stromaufwärts mit der Reaktorkammer (410) verbundene erste Spülflussleitung (405, 411);
   Mittel zum Bereitstellen eines durch die erste Spülflussleitung (405, 411) fließenden ersten Spülflusses und eines zweiten Spülflusses, der größer als der erste Spülfluss ist;
   Mittel (416, 417, 418, 419) zum Durchführen einer Vorläuferstoffinjektion in die Reaktionskammer (410) zusammen mit dem ersten Spülfluss;
   Mittel zum Schalten der Vorläuferstoffinjektionsmittel (416; 417; 418, 419) zwischen einem wirksamen Zustand während einer Abscheideperiode für eine Abscheidung einer atomaren Schicht und eine einem nicht wirksamen Zustand während einer Spülperiode;
   wobei der zweite Spülfluss während der Spülperiode in die Reaktorkammer (410) injiziert wird; und
   eine stromabwärts der Reaktorkammer verbundene Pumpeinrichtung (420, 422,430),
   **gekennzeichnet**
   **durch** eine stromaufwärts des Reaktors (410) verbundene zweite Spülflussleitung (407,409);
   wobei die Pumpeinrichtung (420, 422, 430) ausgelegt ist, umzuschalten zwischen einer ersten Pumpleistung, wenn die erste Spülflussleitung (405, 411) in Wirkung ist und einer zweiten Pumpleistung, die größer ist als die erste Pumpleistung, wenn die zweite Spülflussleitung (407,409) in Wirkung ist.

2. Vorrichtung nach Anspruch 1, wobei die erste und die zweite Spülflussleitung sich ein gemeinsames Anschlussteil mit einer oder mehreren Vorläuferstoffinjektionsleitungen teilen.

3. Vorrichtung nach Anspruch 1, wobei mindestens eine der ersten und zweiten Spülflussleitungen direkt unabhängig von der anderen mit dem Reaktor verbunden ist.

4. Vorrichtung nach Anspruch 1, wobei die beiden Pumpleistungen zwei Betriebszustände einer einzigen physikalischen Pumpe sind.

5. Vorrichtung nach Anspruch 1, aufweisend ferner ein Drosselventil stromabwärts der Reaktorkammer.

6. Vorrichtung nach Anspruch 5, wobei die zweite Pumpleistung zumindest teilweise durch eine stromabwärts mit der Reaktorkammer aber stromaufwärts des Drosselventils verbundenen physikalischen Pumpe erzeugt wird.

7. Vorrichtung nach Anspruch 5, wobei die erste und zweite Pumpleistung von einer oder mehreren Pumpen erzeugt ist, die stromabwärts mit dem Drosselventil verbunden sind.

8. Vorrichtung nach Anspruch 1, wobei die Spülflussleitungen dazu ausgelegt sind, bei ersten und zweiten Spülgasdrücken betrieben zu werden, wobei der erste Druck kleiner ist als der zweite Druck.

9. Vorrichtung nach Anspruch 8, wobei sich die erste und die zweite Spülflussleitung mit einer oder mehreren Vorläuferstoffinjektionsleitungen ein gemeinsames Gasflussanschlussteil teilen.

10. Vorrichtung nach Anspruch 9, wobei zumindest eine der ersten und zweiten Gasflussleitungen direkt unabhängig von der anderen mit dem Reaktor verbunden ist.

11. Vorrichtung nach Anspruch 1, **dadurch gekennzeichnet, dass** der erste und zweite Spülfluss einen auswählbaren stromaufwärtigen flussbeschränkenden Strömungsleitwert aufweist, der zwei oder mehr Betriebszustände hat, beinhaltend einen Niedrigflusszustand und einen Hochflusszustand; und die Pumpeinrichtung einen auswählbaren stromabwärtigen flussbeschränkenden Strömungsleitwert aufweist, der zwei oder mehr Betriebszustände hat, beinhaltend eine Niedrigflusszustand und einen Hochflusszustand, wobei der stromaufwärtige flussbeschränkende Strömungsleitwert und der stromabwärtige flussbeschränkende Strömungsleitwert ausgelegt sind, den Betriebszustand in zeitlicher Phase mit dem anderen zu schalten.

12. Vorrichtung nach Anspruch 11, wobei die stromaufwärtigen flussbeschränkenden Strömungsleitwerte ausgelegt sind, die Betriebszustände vor dem Umschalten der Betriebszustände des stromabwärtigen flussbeschränkenden Strömungsleitwertes umzuschalten.

13. Vorrichtung nach Anspruch 11, wobei der stromabwärtige flussbeschränkende Strömungsleitwert einem Drosselventil zugeordnet ist.

14. Vorrichtung nach Anspruch 13, wobei das Drosselventil ein ringförmiges Drosselventil ausweist, welches innerhalb der Reaktorkammer angeordnet ist.

15. Vorrichtung nach Anspruch 11, wobei die Spülflussleitung mehrere Gasflussleitungen für Spülgase und chemische Vorläuferstoffe aufweist, die sich einen oder mehrere gemeinsame Eingänge in die Reaktorkammer teilen.

16. Vorrichtung nach Anspruch 15, wobei mindestens eine der Spülflussleitungen unabhängig von der Gasflussleitung für den chemischen Vorläuferstoff ist.

17. Vorrichtung nach Anspruch 1, **gekennzeichnet durch** ein mit der Reaktorkammer verbundenes Gasversorgungssystem, aufweisend ein ringförmiges Drosselventil, das in der Gasflussleitung von der Reaktorkammer zu dem stromabwärts mit der Reaktorkammer verbundenen Pumpsystem angeordnet ist.

18. Vorrichtung nach Anspruch 17, wobei das ringförmige Drosselventil zwei oder mehr Betriebszustände hat, wobei jeder dazu ausgelegt ist, einen verschiedenen Strömungsleitwert von der Reaktorkammer aufzuweisen.

19. Vorrichtung nach Anspruch 18, wobei das Gasversorgungssystem ausgelegt ist, Spülflüsse auf zwei oder mehreren Durchflusshöhen vorzusehen.

20. Vorrichtung nach Anspruch 19, wobei das ringförmige Drosselventil mit einem Steuersystem verbunden ist, welches ausgelegt ist, den Betriebszustand des ringförmigen Drosselventils abhängig vom Spülfluss zu schalten, um den Reaktorkammerdruck konstant zu halten.

21. Vorrichtung nach Anspruch 17, **dadurch gekennzeichnet, dass** das ringförmige Drosselventil mehrere Schieber aufweist, welche jeweils eine Achse aufweisen, um welche der jeweilige Schieber von einer ersten Stellung in eine zweite Stellung dreht.

22. Vorrichtung nach Anspruch 17, wobei das ringförmige Drosselventil mehrere in einer Iris-Anordnung angeordnete Flügel aufweist.

23. Vorrichtung nach Anspruch 17, wobei das ringförmige Drosselventil mehrere Flügel aufweist, wobei jeder eine Anzahl von Durchgangsöffnungen aufweist, wobei zumindest einer der Flügel um eine Achse drehbar ist, so dass Löcher, die sich durch den drehbaren Flügel erstrecken, mit Löchern zumindest eines der anderen Flügel überdecken, um einen Durchgang durch das ringförmige Drosselventil zu erreichen.

24. Vorrichtung nach Anspruch 1, **gekennzeichnet durch** eine erste Neutralgasleitung, die ausgelegt ist, um einen Argongasfluss in einen Wirkraum während einer Spülperiode eines Atomlagenabscheidungszyklus einzuspeisen, und eine getrennte zweite Neutralgasleitung, die dazu ausgelegt ist, um einen $N_2$ Gasfluss stromabwärts des Reaktionsraumes einzuspeisen, wobei die beiden Gasflüsse so gewählt sind, um einen im Wesentlichen konstanten Druck in dem Reaktionsraum zu erreichen.

25. Verfahren zum Abscheiden atomarer Schichten (ALD) unter der Verwendung einer Vorrichtung nach einem der vorhergehenden Ansprüche aufweisend

eine Abscheideperiode, in der ein Vorläuferstoff in die Reaktionskammer (410) zusammen mit einem ersten Spülfluss, der durch eine erste Spülflussleitung (405,411), der stromaufwärts der Reaktorkammer (410) verbunden ist, injiziert ist, bei einer ersten Pumpleistung der Pumpeinrichtung; und

eine Spülperiode, in der ein zweiter Spülfluss, der größer ist als der erste Spülfluss in die Reaktionskammer (410) ohne Vorläuferstoff injiziert wird; **dadurch gekennzeichnet,**

**dass** der zweite Spülfluss durch die zweite Spülflussleitung (407, 409) fließt die stromaufwärts der Reaktorkammer (410) verbunden ist, bei einer zweiten Pumpleistung, die größer ist als die erste Pumpleistung.

26. Verfahren nach Anspruch 25, wobei der Druck der Reaktorkammer, innerhalb der das atomare Schichtwachstum stattfindet, während der Abscheideperiode und der Spülperiode nominell konstant gehalten wird.

27. Verfahren nach Anspruch 26, wobei der Druck der Reaktorkammer durch den Betrieb eines Drosselventils stromabwärts der Reaktorkammer nominell konstant gehalten wird, wobei das Drosselventil in der Spülperiode weiter geöffnet ist als in der Abscheideperiode.

28. Verfahren nach Anspruch 25, wobei der erste Spülfluss und der zweite Spülfluss verschiedene Gase beinhalten.

29. Verfahren nach Anspruch 25, wobei der zweite Spülfluss und die zweite Pumpleistung aktiviert werden, bevor die Materialabscheidung während der Abscheideperiode endet.

30. Verfahren nach Anspruch 25, wobei der zweite Spülfluss und die zweite Pumpleistung aktiviert werden, um Turbolenzen in der Reaktorkammer, in welcher der atomare Beschichtungsprozess durchgeführt wird, zu unterbrechen.

31. Verfahren nach Anspruch 25, aufweisend eine zweite Abscheideperiode des atomaren Abscheideprozesses unter Verwendung eines dritten Spülflusses und einer dritten Pumpleistung, die vom ersten Spülfluss und von der ersten Pumpleistung verschieden sind.

32. Verfahren nach Anspruch 31, wobei der dritte Spülfluss das Nichtvorhandensein eines Spülflusses beinhaltet.

33. Verfahren nach Anspruch 25, wobei die Abscheideperiode einen plasmaunterstützten Vorgang beinhaltet.

34. Verfahren nach Anspruch 25, wobei der erste Spülfluss in den zweiten Spülfluss im Wesentlichen zu dem Zeitpunkt umgeschaltet wird, in dem die erste Pumpleistung in die zweite Pumpleistung umgeschaltet wird.

35. Verfahren nach Anspruch 34, wobei der erste Spülfluss in den zweiten Spülfluss vor der Beendigung der Materialabscheidung während des Abscheide-Halbzyklusses in den zweiten Spülfluss umgeschaltet wird.

36. Verfahren nach Anspruch 25, wobei der erste Spülfluss zu einer anderen Zeit in den zweiten Spülfluss umgeschaltet wird, als die erste Pumpleistung in die zweite Pumpleistung umgeschaltet wird.

37. Verfahren nach Anspruch 36, wobei der erste Spülfluss in den zweiten Spülfluss geschaltet wird, bevor die erste Pumpleistung in die zweite Pumpleistung geschaltet wird.

38. Verfahren nach Anspruch 36, wobei der erste Spülfluss nach dem Umschalten der ersten Pumpleistung in die zweite Pumpleistung in den zweiten Spülfluss umgeschaltet wird.

39. Verfahren nach Anspruch 25, wobei der erste Spülfluss in den zweiten Spülfluss geschaltet wird, dass in dem ein erster flussbeschränkender Strömungsleitwert stromaufwärts der Reaktorkammer, in der der atomare Abscheideprozess durchgeführt wird, aus der ersten Gasflussleitung zur Reaktorkammer im Wesentlichen zum selben Zeitpunkt geschaltet ist, zu dem ein zweiter flussbeschränkender Strömungsleitwert, der stromabwärts der Reaktorkammer angeordnet ist, aus der zweiten Gasflussleitung von der Reaktorkammer geschaltet wird.

40. Verfahren nach Anspruch 25, wobei die Verwendung des ersten Spülflusses teilweise durch einen ersten Strömungsleitwert einer ringförmigen Gasleitung innerhalb der Reaktorkammer, in welcher der atomare Abscheidungsprozess durchgeführt wird, definiert ist, und der zweite Spülfluss teilweise durch einen zweiten Strömungsleitwert der ringförmigen Gasleitung innerhalb der Reaktorkammer definiert wird.

41. Verfahren nach Anspruch 40, wobei der Druck der Reaktorkammer während der ersten Periode und der zweiten Periode im Wesentlichen konstant gehalten wird.

42. Verfahren nach Anspruch 40, wobei der erste Spülfluss und der zweite Spülfluss verschiedene Gase beinhalten.

43. Verfahren nach Anspruch 40, wobei der erste Spülfluss und der zweite Spülfluss durch voneinander verschiedene Leitungen fließen.

44. Verfahren nach Anspruch 40, wobei der zweite Spülfluss vor der Beendigung der Materialabscheidung während der ersten Periode aktiviert wird.

45. Verfahren nach Anspruch 40, wobei eine dritte Periode des atomaren Abscheidezyklusses vorgesehen ist, bei dem ein dritter Spülfluss teilweise durch einen dritten Strömungsleitwert der ringförmigen Gasleitung definiert ist und verschieden ist vom ersten und vom zweiten Spülfluss.

46. Verfahren nach Anspruch 45, wobei der dritte Spülfluss einen nicht vorhandenen Spülfluss aufweist.

47. Verfahren nach Anspruch 40, wobei die erste Periode einen plasmaunterstützten Vorgang beinhaltet.

48. Verfahren nach Anspruch 25, wobei der erste Spülfluss in den zweiten Spülfluss teilweise durch Schalten eines ersten flussbeschränkenden Strömungsleitwertes oberhalb der Reaktorkammer aus einer ersten Gasflussleitung zur Reaktorkammer geschaltet wird, wobei im Wesentlichen zum selben Zeitpunkt, bei dem der zweite Strömungsleitwert der ringförmigen Gasflussleitung innerhalb der Reaktorkammer in eine zweite Gasflussleitung von der Reaktorkammer geschaltet wird.

49. Verfahren nach einem der vorhergehenden Ansprüche, wobei der erste Spülfluss bei einem ersten Druck durch einen ersten strömungsbegrenzenden Strömungsleitwert hindurchtritt, der in der ersten Gasflussleitung oberhalb der Reaktorkammer angeordnet ist, in welcher die atomare Schichtabscheidung durchgeführt wird, und ein zweiter flussbeschränkender Strömungsleitwert in der zweiten Gasleitung stromabwärts der Reaktorkammer vorgesehen ist und die Spülperiode des atomaren Abscheideprozesses den zweiten Spülfluss verwendet, wobei der zweite Spülfluss durch einen dritten Strömungswert hindurchtritt, der innerhalb der ersten Gasleitung angeordnet ist und wobei ein vierter Strömungsleitwert in der zweiten Gasleitung vorgesehen ist, wobei das Verhältnis des ersten Strömungsleitwertes zum zweiten Strömungsleitwert gleich dem Verhältnis des dritten Strömungsleitwertes zum vierten Strömungsleitwert ist und der Druck innerhalb der Reaktorkammer während des atomaren Beschichtungsprozesses nominell konstant gehalten wird.

50. Verfahren nach Anspruch 49, wobei das zweite Spülgas, welches für den zweiten Spülfluss verwendet wird, verschieden ist vom ersten Spülgas, das für den ersten Spülfluss verwendet wird.

51. Verfahren nach Anspruch 49, wobei die Abscheideperiode einen plasmaunterstützten Vorgang aufweist.

**52.** Verfahren nach Anspruch 49, wobei der erste Spülfluss in den zweiten Spülfluss im Wesentlichen zur selben Zeit geschaltet wird, zu der der erste Strömungsleitwert innerhalb der ersten Gasflussleitung in den dritten Strömungsleitwert geschaltet wird.

**53.** Verfahren nach Anspruch 49, wobei der erste Spülfluss vor der Vervollständigung der Materialabscheidung während der Abscheideperiode in den zweiten Spülfluss geschaltet wird.

**54.** Verfahren nach Anspruch 49, wobei der erste Spülfluss zu einem Zeitpunkt in den zweiten Spülfluss geschaltet ist, der verschieden ist zu dem Zeitpunkt, zu dem der zweite Strömungsleitwert in der zweiten Gasflussleitung in den vierten Strömungsleitwert geschaltet wird.

**Revendications**

**1.** Appareil de dépôt de couche atomique (DCA), comportant :

une chambre de réacteur (410) ;
un premier chemin d'écoulement de purge (405, 411) couplé en amont de la chambre de réacteur (410) ;
des moyens pour générer un premier écoulement de purge à travers le premier chemin d'écoulement de purge (405, 411) et un deuxième écoulement de purge qui est supérieur au premier écoulement de purge ;
des moyens (416, 417 ; 418, 419) pour effectuer une injection de précurseur dans la chambre de réaction (410) ainsi que pour générer le premier écoulement de purge ;
des moyens pour commuter les moyens d'introduction de précurseur (416, 417 ; 418, 419) entre un état actif pendant une période d'exposition d'un dépôt de couche atomique et un état non-actif pendant une période de purge ;
le deuxième écoulement de purge étant introduit dans la chambre de réacteur (410) pendant la période de purge ; et
un système de pompage (420, 422, 430) couplé en aval de la chambre de réacteur (410),

**caractérisé**
**par** un deuxième chemin d'écoulement de purge (407, 409) couplé en amont du réacteur (410) et destiné au deuxième écoulement de purge ;
le système de pompage (420, 422, 430) étant configuré pour être commuté entre une première capacité de pompage lorsque le premier chemin d'écoulement de purge (405, 411) est actif et une deuxième capacité de pompage supérieure à la première capacité de pompage lorsque le deuxième chemin d'écoulement de purge (407, 409) est actif.

**2.** Appareil DCA selon la revendication 1, dans lequel les premier et deuxième chemins d'écoulement de purge partagent un collecteur d'écoulement de gaz commun comportant un ou plusieurs chemins d'introduction de précurseur.

**3.** Appareil DCA selon la revendication 1, dans lequel l'un au moins des premier et deuxième chemins d'écoulement de purge est directement couplé au réacteur indépendamment de l'autre.

**4.** Appareil DCA selon la revendication 1, dans lequel les première et deuxième capacités de pompage présentent deux modes de fonctionnement d'une pompe physique simple.

**5.** Appareil DCA selon la revendication 1, comportant en outre une valve de commande en aval de la chambre de réacteur.

**6.** Appareil DCA selon la revendication 5, dans lequel la deuxième capacité de pompage est fournie, au moins en partie, par une pompe physique couplée en aval de la chambre de réacteur mais en amont de la valve de commande.

**7.** Appareil DCA selon la revendication 5, dans lequel les première et deuxième capacités de pompage sont fournies par une ou plusieurs pompes couplées en aval de la valve de commande.

**8.** Appareil DCA selon la revendication 1, dans lequel les premier et deuxième chemins d'écoulement de purge sont configurés pour fonctionner à des première et deuxième pressions de gaz de purge, respectivement, la première pression étant inférieure à la deuxième pression.

9. Appareil DCA selon la revendication 8, dans lequel les premier et deuxième chemins d'écoulement de purge partagent un collecteur d'écoulement de gaz commun comportant un ou plusieurs chemins d'introduction de précurseur.

10. Appareil DCA selon la revendication 9, dans lequel l'un au moins des premier et deuxième chemins d'écoulement de purge est directement couplé au réacteur indépendamment de l'autre.

11. Appareil DCA selon la revendication 1, **caractérisé en ce que** les premier et deuxième écoulements de purge comportent une conductance de limitation d'écoulement amont sélectionnable ayant deux modes de fonctionnement ou plus incluant un mode à écoulement faible et un mode à écoulement élevé ; et le système de pompage comporte une conductance de limitation d'écoulement aval sélectionnable ayant deux modes de fonctionnement ou plus incluant un mode à écoulement faible et un mode à écoulement élevé, la conductance de limitation d'écoulement amont et la conductance de limitation d'écoulement aval étant configurées pour commuter en terme de phase-temps d'un mode de fonctionnement à l'autre.

12. Appareil DCA selon la revendication 11, dans lequel la conductance de limitation d'écoulement amont est configurée pour commuter d'un mode de fonctionnement à l'autre avant que la conductance de limitation d'écoulement aval ne commute d'un mode de fonctionnement à l'autre.

13. Appareil DCA selon la revendication 11, dans lequel la conductance de limitation d'écoulement aval inclut une valve de commande.

14. Appareil DCA selon la revendication 13, dans lequel la valve de commande comporte une valve de commande annulaire située à l'intérieur de la chambre de réacteur.

15. Appareil DCA selon la revendication 11, dans lequel le chemin d'écoulement de purge comporte de multiples chemins d'écoulement de gaz destinés à des gaz de purge et à des précurseurs chimiques qui partagent une ou plusieurs entrées communes de la chambre de réacteur.

16. Appareil DCA selon la revendication 15, dans lequel l'un au moins des chemins d'écoulement de gaz de purge est indépendant des chemins d'écoulement de gaz destinés aux précurseurs chimiques.

17. Appareil DCA selon la revendication 1, **caractérisé par** un système de délivrance de gaz couplé à la chambre de réacteur dans lequel est disposée une valve de commande annulaire placée dans un chemin d'écoulement de gaz allant de la chambre de réacteur au système de pompage couplé en aval de la chambre de réacteur.

18. Appareil DCA selon la revendication 17, dans lequel la valve de commande annulaire a deux modes de fonctionnement ou plus, configurés chacun pour conférer au chemin d'écoulement une conductance différente de celle de la chambre de réacteur.

19. Appareil DCA selon la revendication 18, dans lequel le système de délivrance de gaz est configuré pour conférer deux niveaux d'écoulement ou plus aux écoulements de purge.

20. Appareil DCA selon la revendication 19, dans lequel la valve de commande annulaire est couplée à un système de commande configuré pour que la valve de commande annulaire commute d'un mode de fonctionnement à l'autre en fonction d'un niveau d'écoulement de purge afin de maintenir une pression nominalement constante dans la chambre de réacteur.

21. Appareil DCA selon la revendication 17, dans lequel la valve de commande annulaire inclut de multiples pales, chacune d'elles étant traversée par un axe autour duquel une pale individuelle tourne d'une première position à une deuxième position.

22. Appareil DCA selon la revendication 17, dans lequel la valve de commande annulaire inclut de multiples lames disposées dans une configuration en iris.

23. Appareil DCA selon la revendication 17, dans lequel la valve de commande annulaire inclut de multiples lames, chacune d'elles comportant un certain nombre de trous, l'une au moins des lames étant rotatives autour d'un axe de telle sorte que les trous passant à travers la lame rotative s'alignent avec des trous de l'une au moins des autres lames afin de ménager un passage à travers la valve de commande.

24. Appareil DCA selon la revendication 1, **caractérisé par** une première ligne de gaz neutre configurée pour introduire un niveau d'écoulement de gaz Ar dans un espace de réaction pendant une période de purge d'un cycle DCA, et une deuxième ligne de gaz neutre distincte configurée pour introduire un niveau d'écoulement de gaz N2 en aval de l'espace de réaction, les niveaux d'écoulement de gaz étant choisis afin de conférer à l'espace de réaction une pression sensiblement constante.

25. Procédé de dépôt de couche atomique (DCA) à l'aide d'un appareil selon l'une des revendications précédentes réalisant
une période d'exposition dans laquelle un précurseur est introduit dans la chambre de réaction (410) conjointement avec le premier écoulement de purge traversant le premier chemin d'écoulement de purge (405, 411) couplé en amont de la chambre de réacteur (410) à une première capacité de pompage du système de pompage ; et
une période de purge dans laquelle un deuxième écoulement de purge supérieur au premier écoulement de purge est introduit dans la chambre de réaction (410) sans précurseur ;
**caractérisé en ce que** le deuxième écoulement de purge s'écoule à travers le deuxième chemin d'écoulement de purge (407, 409) couplé en amont de la chambre de réacteur (410) à une deuxième capacité de pompage supérieure à la première capacité de pompage.

26. Procédé selon la revendication 25, comprenant en outre le maintien d'une pression dans une chambre de réacteur, dans laquelle se déroule le processus DCA, à une valeur nominalement constante pendant la période d'exposition et la période de purge.

27. Procédé selon la revendication 26, dans lequel la pression dans la chambre de réacteur est maintenue à une valeur nominalement constante au moyen d'une valve de commande en aval de la chambre de réacteur de sorte que la valve de commande est davantage ouverte pendant la période de purge que pendant la période d'exposition.

28. Procédé selon la revendication 25, dans lequel le premier écoulement de purge et le deuxième écoulement de purge comportent différents gaz.

29. Procédé selon la revendication 25, dans lequel le deuxième écoulement de purge et la deuxième capacité de pompage sont activés avant la fin du dépôt de matière pendant la période d'exposition.

30. Procédé selon la revendication 25, dans lequel le deuxième écoulement de purge et la deuxième capacité de pompage sont activés afin d'arrêter la turbulence existante à l'intérieur d'une chambre de réacteur dans laquelle se déroule le processus DCA.

31. Procédé selon la revendication 25, comprenant en outre la mise en oeuvre d'une deuxième période d'exposition du processus DCA au moyen d'un troisième écoulement de purge et d'une troisième capacité de pompage respectivement différents du premier écoulement de purge et de la première capacité de pompage.

32. Procédé selon la revendication 31, dans lequel le troisième écoulement de purge comporte une absence d'écoulement de purge.

33. Procédé selon la revendication 25, dans lequel la période d'exposition comporte un processus assisté par plasma.

34. Procédé selon la revendication 25, dans lequel l'on commute du premier écoulement de purge au deuxième écoulement de purge sensiblement au même moment que l'on commute de la première capacité de pompage à la deuxième capacité de pompage.

35. Procédé selon la revendication 34, dans lequel l'on commute du premier écoulement de purge au deuxième écoulement de purge avant la fin du dépôt de matière pendant le demi-cycle d'exposition.

36. Procédé selon la revendication 25, dans lequel l'on commute du premier écoulement de purge au deuxième écoulement de purge à un moment différent de celui où l'on commute de la première capacité de pompage à la deuxième capacité de pompage.

**37.** Procédé selon la revendication 36, dans lequel l'on commute du premier écoulement de purge au deuxième écoulement de purge avant de commuter de la première capacité de pompage à la deuxième capacité de pompage.

**38.** Procédé selon la revendication 36, dans lequel l'on commute du premier écoulement de purge au deuxième écoulement de purge après avoir commuté de la première capacité de pompage à la deuxième capacité de pompage.

**39.** Procédé selon la revendication 25, dans lequel l'on commute du premier écoulement de purge au deuxième écoulement de purge en faisant commuter la première conductance de limitation d'écoulement en amont d'une chambre de réacteur, dans laquelle se déroule le processus DCA, hors d'un premier chemin d'écoulement de gaz menant à la chambre de réacteur sensiblement au même moment que l'on commute la deuxième conductance de limitation d'écoulement en aval de la chambre de réacteur hors d'un deuxième chemin d'écoulement de gaz venant de la chambre de réacteur.

**40.** Procédé selon la revendication 25, dans lequel l'on utilise le premier écoulement de purge défini en partie par une première conductance d'un chemin d'écoulement de gaz annulaire à l'intérieur de la chambre de réacteur, dans laquelle se déroule le processus DCA, et le deuxième écoulement de purge défini en partie par une deuxième conductance du chemin d'écoulement de gaz annulaire à l'intérieur de la chambre de réacteur.

**41.** Procédé selon la revendication 40, comportant en outre le maintien d'une pression de la chambre de réacteur à une valeur nominalement constante pendant la première période et la deuxième période.

**42.** Procédé selon la revendication 40, dans lequel le premier écoulement de purge et le deuxième écoulement de purge comportent différents gaz.

**43.** Procédé selon la revendication 40, dans lequel le premier écoulement de purge et le deuxième écoulement de purge passent par des chemins d'écoulement différents.

**44.** Procédé selon la revendication 40, dans lequel le deuxième écoulement de purge est activé avant la fin du dépôt de matière pendant la première période.

**45.** Procédé selon la revendication 40, comportant en outre la mise en oeuvre d'une troisième période du cycle DCA au moyen d'un troisième écoulement de purge défini en partie par une troisième conductance du chemin d'écoulement de gaz annulaire et différent des premier et deuxième écoulements de purge.

**46.** Procédé selon la revendication 45, dans lequel le troisième écoulement de purge comporte une absence d'écoulement de purge.

**47.** Procédé selon la revendication 40, dans lequel la première période comporte un processus assisté par plasma.

**48.** Procédé selon la revendication 25, dans lequel l'on commute du premier écoulement de purge au deuxième écoulement de purge en partie en faisant commuter la première conductance de limitation d'écoulement en amont de la chambre de réacteur hors d'un premier chemin d'écoulement de gaz menant à la chambre de réacteur sensiblement au même moment que l'on commute la deuxième conductance du chemin d'écoulement de gaz annulaire à l'intérieur la chambre de réacteur vers un deuxième chemin d'écoulement de gaz venant de la chambre de réacteur.

**49.** Procédé selon l'une des revendications précédentes, dans lequel on met en oeuvre le premier écoulement de purge à une première pression, le premier écoulement de purge à travers une première conductance de limitation d'écoulement à l'intérieur du premier chemin d'écoulement de gaz en amont de la chambre de réacteur, dans laquelle se déroule le processus DCA, et une deuxième conductance de limitation d'écoulement à l'intérieur du deuxième chemin d'écoulement de gaz en aval de la chambre de réacteur, et on met en oeuvre la période de purge du processus DCA à l'aide du deuxième écoulement de purge, le deuxième écoulement de purge à travers une troisième conductance à l'intérieur du premier chemin d'écoulement de gaz et une quatrième conductance à l'intérieur du deuxième chemin d'écoulement de gaz, un rapport de la première conductance sur la deuxième conductance étant égal à un rapport de la troisième conductance sur la quatrième conductance et une pression dans la chambre de réacteur étant maintenue à une valeur nominalement constante pendant le processus DCA.

**50.** Procédé selon la revendication 49, dans lequel un deuxième gaz de purge utilisé pour le deuxième écoulement de purge est différent d'un premier gaz de purge utilisé pour le premier écoulement de purge.

**51.** Procédé selon la revendication 49, dans lequel la période d'exposition comporte un processus assisté par plasma.

**52.** Procédé selon la revendication 49, dans lequel l'on commute du premier écoulement de purge au deuxième écoulement de purge sensiblement au même moment que l'on commute de la première conductance à l'intérieur du premier chemin d'écoulement de gaz à la troisième conductance.

**53.** Procédé selon la revendication 49, dans lequel l'on commute du premier écoulement de purge au deuxième écoulement de purge avant la fin du dépôt de matière pendant la période d'exposition.

**54.** Procédé selon la revendication 49, dans lequel l'on commute du premier écoulement de purge au deuxième écoulement de purge à un moment différent de celui où l'on commute de la deuxième conductance dans le deuxième chemin d'écoulement de gaz à la quatrième conductance.

# Fig. 1 (Prior Art)

# Fig. 2

EP 1 613 792 B1

Reactor
Total Flow
(sccm)

Baseline
Purge Flow

Reactor
Total Pressure
(Torr)

Baseline
Pressure
(Due to purge)

Fig. 3A

# Fig. 3B

EP 1 613 792 B1

# Fig. 4

EP 1 613 792 B1

# Fig 5

500

EP 1 613 792 B1

# Fig. 6

EP 1 613 792 B1

# Fig. 7

EP 1 613 792 B1

Fig. 8

# Fig. 9

958

Wedge Shaped Vane ATV
960

962
964

Iris Diaphragm ATV
966

968

Baffle ATV
970

972

On
Off

EP 1 613 792 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20020076508 A1
- US 200300133201 A
- US 6200893 B, Sneh
- WO 03062490 A2, Sneh. See O. Sneh
- US 6503330 B
- WO 0079019 A, Gadgil

### Non-patent literature cited in the description

- Deposition and Processing. **M. RITALA ; M. LESKE-LA.** Handbook of Thin Film Materials. 2002, vol. 1
- **STEVEN SHATAS.** *Modular Process Technology of San Jose,* 1998
- **K.J. LAIDLER.** *Chemical Kinetics,* 1987, 81-87